# EUROPEAN PATENT SPECIFICATION

(11) **EP 2 264 944 B1**
(45) Date of publication and mention of the grant of the patent: **12.08.2015**
(21) Application number: 10007182.8
(22) Date of filing: 22.01.2009
(51) Int. Cl.: H04L 12/26, G01R 13/00, G01R 31/00

(54) **Communication analysis apparatus and communication analysis method**
Kommunikationsanalysevorrichtung und Kommunikationsanalyseverfahren
Appareil d'analyse de communication et procédé d'analyse de communication

(30) Priority: 01.02.2008 JP 2008022489; 14.04.2008 JP 2008104274
(43) Date of publication of application: 22.12.2010
(62) Divisional of application: 09705319.3
(73) Proprietor: Mitsubishi Electric Corporation, Tokyo 100-8310 (JP)
(72) Inventor: Kuroiwa, Takeru, Tokyo 100-8310 (JP); Nakata, Masanori, Tokyo 100-8310 (JP)
(74) Representative: Hopkin, Tobias J.B.

(56) References cited:
- EP-A2- 1 562 131
- US-A1- 2007 070 691

## Description

### Technical Field

The present invention relates to a communication analysis apparatus for supporting an analysis of a transmission failure of a network.

### Background Art

If the shape of a waveform signal passing through a transmission path is disturbed for some reason and thus the signal intended by the command source cannot be maintained until the signal reaches the command destination, a network transmission failure occurs. Therefore, an analysis of a physical layer level of the network is required as a diagnosis of such a transmission failure.

As a related-art example of a waveform signal analysis and as a related-art example intended to easily conduct a communication analysis by presenting a communication sequence and a physical amount in such a manner that the communication sequence and physical amount are associated with each other, for example, there has been proposed a communication test apparatus where "display means 108 disposes and displays, in chronological order, the sequence log display and power log display 9 showing the presence or absence of a communication from the power log information in a distinguishable manner" (for example, see Patent Document 1).

Also, as a related-art example intended to detect a communication interference wave by controlling a parameter as appropriate with respect to display of an analysis result, for example, there has been proposed a digital modulation signal evaluation apparatus where "a threshold setup unit 37 obtains a threshold R for determining the presence or absence of an interference wave on the basis of a modulation error ratio of a sub-carrier not included in an interference range expected to be interfered with by a interference wave among stored modulation error ratios and a determination unit 38 compares the threshold R with the modulation error ratio of the sub-carrier included in the interference range so as to determine whether there is an interference wave, and displays a result of the determination" (for example, see Patent Document 2).

Among related-art examples of a physical layer level analysis are the above-mentioned Patent Document 1 and a transmission signal analysis apparatus (for example, see Patent Document 3) that previously sets an ideal pilot signal for an OFDM-type transmission signal and analyzes an actual pilot signal using the ideal pilot signal.

EP 1 562 131 discloses a method for capturing an analog waveform on a serial bus, comprising designating a predetermined digital data sequence; decoding a serial data signal carried on a serial data bus; comparing the decoded serial data signal to the predetermined digital data sequence; and when it is determined that a portion of the decoded serial data matches the predetermined digital data sequence, marking the portion of the serial data signal corresponding to the matching portion of the decoded serial data signal.

### Related-Art Documents

### Patent Documents

[Patent Document 1] Japanese Unexamined Patent Application Publication No. 2006-33007 (Claim 4, pp. 15 to 21, Figs. 1 to 2)
[Patent Document 2] Japanese Unexamined Patent Application Publication No. 2005-311570 (ABSTRACT)
[Patent Document 3] Japanese Unexamined Patent Application Publication No. 2006-245972 (pp. 6 to 7, Figs. 1 to 6)

### Summary of the Invention

### Problems to be Solved by the Invention

In the related-art failure analyses, an apparatus for analyzing communication messages and an apparatus for analyzing waveform signals exist independently. This causes a problem that it is not easy to analyze a failure in such a manner that a communication message and a waveform signal are associated with each other and thus the workload is increased.

While there are multiple waveform signal analysis techniques such as the power spectrum analysis, constellation analysis, or MER (modulation error ratio) analysis, analysis functions are independent of one another in related-art apparatuses. This causes a problem that it is difficult to read an association between analysis results.

In the related-art failure analyses, a worker can estimate the communication state qualitatively by observing a voltage level, a frequency component, an in-phase component and an out-of-phase component, or the like of a waveform signal passing through a transmission path. However, it is not easy for the worker to estimate the communication state quantitatively. Therefore, if a failure occurs on a network, only experts having expertise or experience about communication protocols or waveform signals can cope with the failure.

The present invention was made to solve the above-mentioned problems and an object of the invention is to obtain a communication analysis apparatus allowed to analyze a communication message and a waveform signal in such a manner that the communication message and waveform signal are associated with each other.

According to the present invention there is provided a communication analysis apparatus as specified in claim 1.

Preferred embodiments are covered by the dependent claims.
[Fig. 1] Fig. 1 is a diagram showing a configuration of a communication analysis apparatus 100 according to a first embodiment of the present invention.
[Fig. 2] Fig. 2 is a diagram showing a configuration of division organization information-added measurement data 200 according to the first embodiment of the present invention.
[Fig. 3] Fig. 3 is a diagram showing a configuration of division organization information 300 according to the first embodiment of the present invention.
[Fig. 4] Fig. 4 is diagram showing operations in an analysis and synchronization procedure 1B according to the first embodiment of the present invention.
[Fig. 5] Fig. 5 is a diagram showing a method for associating a communication message 201a and a waveform signal 201b with each other using the division organization information 300 according to the first embodiment of the present invention.
[Fig. 6] Fig. 6 is a block diagram showing a configuration of a communication analysis apparatus 100A according to a second embodiment of the present invention.
[Fig. 7] Fig. 7 is a diagram showing a configuration of division organization information-added data 200A.
[Fig. 8] Fig. 8 is a diagram showing a configuration of division organization information 300A.
[Fig. 9] Fig. 9 is a conceptual diagram showing a method by which synchronization determination means 108A associates a communication message 201aA and a waveform signal 201bA with each other using the division organization information 300A.
[Fig. 10] Fig. 10 is a drawing showing a configuration of an analysis part determination table 1091A.
[Fig. 11] Fig. 11 is a conceptual diagram showing a generation process and a configuration of analysis waveform information 400aA.
[Fig. 12] Fig. 12 is a drawing showing the contents of quantitative estimations made by communication state determination means 113A.

### Reference Numerals

100 communication analysis apparatus
101 communication means
102 waveform measuring means
103 division organization information-added communication message storage means
104 division organization information-added waveform signal storage means
105 communication unit division organization information addition means
106 communication unit synchronization determination means
1061 communication unit synchronization determination condition
107 modulation unit division organization information addition means
108 modulation unit synchronization determination means
1081 modulation unit synchronization determination condition
109 communication analysis means
1091 communication analyzer
10911communication analyzer label
10912communication analysis subject
10913communication analysis unit
10921communication analyzer label
110 waveform analysis means
1101 waveform analyzer
11011waveform analyzer label
11012waveform analysis subject
11013waveform analysis unit
111 division organization information-added display data generation means
1111 display data generator
11111 display data label
11112generation subject
11113generation unit
112 division organization information-added display data storage means
113 display data specification means
114 association ID display data extraction means
115 analysis result display means
200 division organization information-added measurement data
200a division organization information-added communication message
200b division organization information-added waveform signal
200c division organization information-added display data
201 measurement data
201a communication message
201b waveform signal
201c display data
202 measurement data information
202almessage acquisition time
202blwaveform acquisition time
202b2sampling rate
202c2generation subject range
203 division organization information processing flag
203alcommunication unit extraction flag
203a2communication unit synchronization determination flag
203a3modulation unit extraction flag
203a4modulation unit synchronization determination flag
203a5communication analysis flag
203blcommunication unit extraction flag
203b2communication unit synchronization determination flag
203b3modulation unit extraction flag
203b4modulation unit synchronization determination flag
203b5waveform analysis flag
300 division organization information
300almessage communication unit division organization information
300a2message modulation unit division organization information
300blwaveform communication unit division organization information
300b2waveform modulation unit division organization information
300cldisplay division organization information
300c2selection division organization information
301 basic information
3011 division unit
3012 basic ID
3013 division position
3014 division time
3015 measurement data type
302 associated information
3021 association ID
303 analysis information
3031 analysis label
3032 analysis value
100A communication analysis apparatus
101A communication means
102A waveform measuring means
103A division organization information-added communication message storage means
104A division organization information-added waveform signal storage means
105A message division organization information addition means
106A waveform division organization information addition means
107A message analysis means
108A synchronization determination means
114A analysis result display means
200A division organization information-added data
200aAdivision organization information-added communication message
200bAdivision organization information-added waveform signal
201A data
201aAcommunication message
201bAwaveform signal
202A data information
202a1A message acquisition time
202b1A waveform acquisition time
203A division organization information processing flag
203a1A communication unit extraction flag
203a2A message analysis flag
203a3A synchronization determination flag
203b1A communication unit extraction flag
203b2A synchronization determination flag
300A division organization information
300aAmessage division organization information
300bAwaveform division organization information
301A basic information
302A associated information
303A analysis information
400aAanalysis waveform information
400bAideal waveform information
401aAanalysis part waveform signal
402aAcharacteristic amount label
403aAcharacteristic amount
404aAcommunication state value
1071Amessage analyzer
10711A message analyzer label
10712A message analysis subject
1091Aanalysis part determination table
1111Acharacteristic amount calculator
11111A characteristic amount label
11112a calculation subject data
1131Acommunication state determination table
3011Adivision unit
3012Abasic ID
3013Adivision position
3014Adivision time
3015Adata type
3021Aassociation ID
3031Aanalysis label
3032Aanalysis value
10911A analysis part start position
10912A analysis part end position,

### Best Modes for Carrying Out the Invention

### First Embodiment

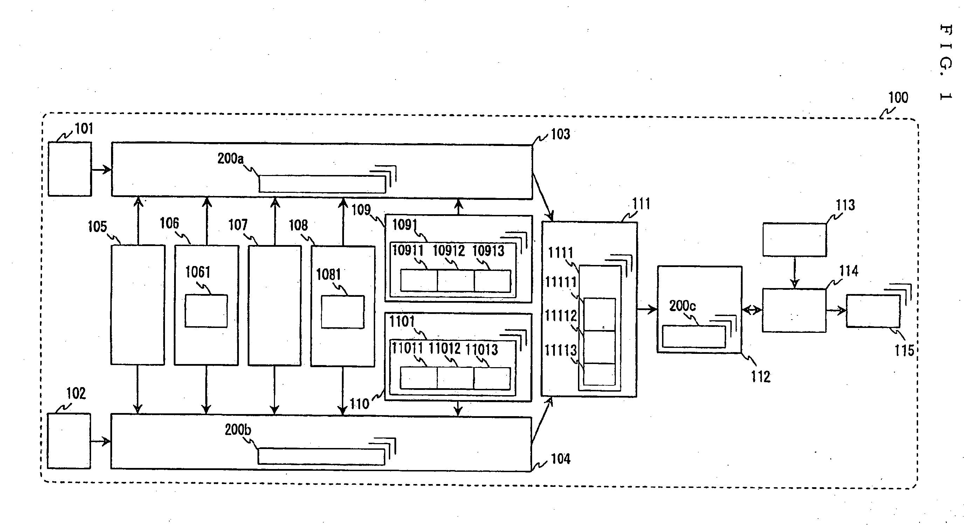

Fig. 1 is a diagram showing a configuration of a communication analysis apparatus 100 according to a first embodiment of the present invention. As shown in Fig. 1, the communication analysis apparatus 100 for analyzing data acquired from a transmission path of a communication network includes a communication means 101, a waveform measuring means 102, a division organization information-added communication message storage means 103, a division organization information-added waveform signal storage means 104, a communication unit division organization information addition means 105, a communication unit synchronization determination means 106, a modulation unit division organization information addition means 107, a modulation unit synchronization determination means 108, a communication analysis means 109, a waveform analysis means 110, a division organization information-added display data generation means 111, a division organization information-added display data storage means 112, a display data specification means 113, an association ID display data extraction means 114, and one or more analysis result display means 115.

Any network such as in-house communication, power line communication, wireless communication, or inter-control apparatus communication may be used as a communication network. Also, an air-conditioner may be used as a control apparatus in inter-control apparatus communications. Also, a transmission path of a network may be wired or wireless.

The communication unit division organization information addition means 105 or modulation unit division organization information addition means 107 corresponds to division organization information addition means according to the present invention.
The division organization information-added communication message storage means 103 or division organization information-added waveform signal storage means 104 corresponds to division organization information-added data generation means according to the present invention.
The communication unit synchronization determination means 106 or modulation unit synchronization determination means 108 corresponds to synchronization determination means according to the present invention.
The division organization information-added communication message storage means 103, division organization information-added waveform signal storage means 104, and communication unit synchronization determination means 106, or modulation unit synchronization determination means 108 correspond to data synchronization means according to the present invention.
The communication analysis means 109 or waveform analysis means 110 corresponds to signal analysis means according to the present invention.
The division organization information-added display data storage means 112 corresponds to display range data storage means according to the present invention.
The association ID display data extraction means 114 corresponds to association display data extraction means according to the present invention.
The division organization information-added display data storage means 112, display data specification means 113, association ID display data extraction means 114, and analysis result display means 115 correspond to signal analysis result display means according to the present invention.

The division organization information-added communication message storage means 103 stores one or more division organization information-added communication messages 200a.
The division organization information-added waveform signal storage means 104 stores one or more division organization information-added waveform signals 200b.
The communication unit synchronization determination means 106 has a communication unit synchronization determination condition 1061.
The modulation unit synchronization determination means 108 has a modulation unit synchronization determination condition 1081.

The communication analysis means 109 includes one or more communication analyzers 1091. The communication analyzers 1091 include a communication analyzer label 10911, a communication analysis subject 10912, and a communication analysis unit 10913. The communication analyzers 1091 may be any analyzers such as an address analyzer for deriving the destination address or source address of a communication message or a CRC error determination apparatus for deriving a CRC error of a communication message.

The waveform analysis means 110 includes one or more waveform analyzers 1101. The waveform analyzers 1101 include a waveform analyzer label 11011, a waveform analysis subject 11012, and a waveform analysis unit 11013. The waveform analyzers 1101 may be any analyzers such as a Fourier transformer for deriving a frequency component of a waveform signal, an I-Q calculator for deriving an in-phase component and an out-of-phase component of a waveform signal, an MER calculator for deriving the fluctuation amounts of an in-phase component and an out-of-phase component, a disturbance diagnostic apparatus for inferring a disturbing factor of a waveform signal, or a spectrum calculator for calculating a power spectrum of a waveform signal.

The division organization information-added display data generation means 111 includes one or more display data generators 1111. The display data generators 1111 have a display data label 11111, a generation subject 11112, and a generation unit 11113.
The division organization information-added display data storage means 112 stores one or more pieces of division organization information-added display data 200c.

The analysis result display means 115 may be any display means such as a spectrum display means for displaying a power spectrum of a waveform signal, a constellation display means for displaying an in-phase component and an out-of-phase component of a waveform signal, an MER display means for displaying an MER of a waveform signal, or a disturbance display means for displaying an inference result of a disturbance factor of a waveform signal.

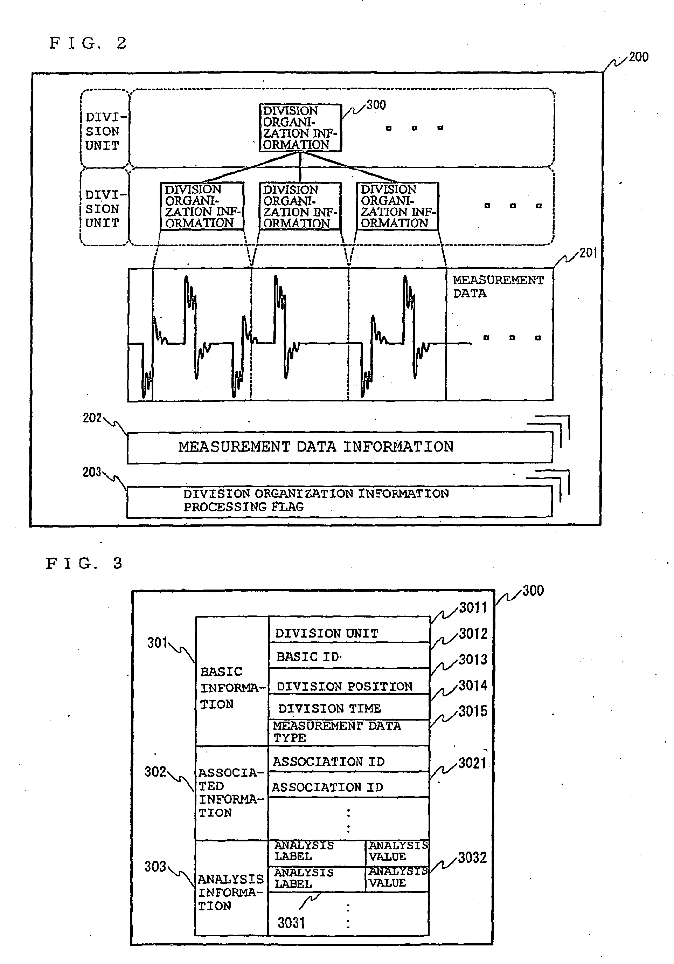

Fig. 2 is a diagram showing a configuration of division organization information-added measurement data 200 according to the first embodiment of the present invention. As shown in Fig. 2, the division organization information-added measurement data 200 includes zero or more pieces of division organization information 300, one or more pieces of measurement data 201, zero or more pieces of measurement data information 202 that are pieces of data information, and zero or more division organization information processing flags 203.

Fig. 3 is a diagram showing a configuration of the division organization information 300 according to the first embodiment of the present invention. As shown in Fig. 3, the division organization information 300 includes basic information 301, associated information 302, and analysis information 303.
The basic information 301 includes a division unit 3011 that is division unit information, a basic ID 3012, a division position 3013, a division time 3014 that is division position information, and a measurement data type 3015.
The associated information 302 includes zero or more association IDs 3021.
The analysis information 303 includes zero or more sets of an analysis label 3031 and an analysis value 3032.

Configurations of the above-mentioned division organization information-added communication messages 200a, division organization information-added waveform signals 200b, and division organization information-added display data 200c imitate a configuration of the division organization information-added measurement data 200.

That is, the division organization information-added communication messages 200a include, as division organization information 300, message communication unit division organization information 300a1 where the division unit 3011 is the communication unit and message modulation unit division organization information 300a2 where the division unit 3011 is the modulation unit.
Also, the division organization information-added communication messages 200a include a communication message 201a as measurement data 201.
Also, the division organization information-added communication messages 200a include a message acquisition time 202a1 as measurement data information 202.
Also, the division organization information-added communication messages 200a include, as division organization information processing flags 203, a communication unit extraction flag 203a1, a communication unit synchronization determination flag 203a2, a modulation unit extraction flag 203a3, a modulation unit synchronization determination flag 203a4, and a communication analysis flag 203a5.
Operations for generating each information will be described later.

The division organization information-added waveform signals 200b include, as division organization information 300, waveform communication unit division organization information 300b1 where the division unit 3011 is the communication unit and waveform modulation unit division organization information 300b2 where the division unit 3011 is the modulation unit.
Also, the division organization information-added waveform signals 200b include a waveform signal 201b as measurement data 201.
Also, the division organization information-added waveform signal 200b includes a waveform acquisition time 202b1 and a sampling rate 202b2 as measurement data information 202.
Also, the division organization information-added waveform signal 200b includes, as division organization information processing flags 203, a communication unit extraction flag 203bl, a communication unit synchronization determination flag 203b2, a modulation unit extraction flag 203b3, a modulation unit synchronization determination flag 203b4, and a waveform analysis flag 203b5.
Operations for generating each information will be described later.

The above-mentioned flags are set by the communication unit division organization information addition means 105, communication unit synchronization determination means 106, modulation unit division organization information addition means 107, modulation unit synchronization determination means 108, communication analysis means 109, and waveform analysis means 110 by performing operations to be described later.

The division organization information-added display data 200c includes, as division organization information 300, display division organization information 300c1 where the division unit 3011 is a display range number (to be described later) and selection division organization information 300c2 where the division unit 3011 is a display range number (to be described later).
Also, the division organization information-added display data 200c includes display data 201c as measurement data 201.
Also, the division organization information-added display data 200c includes, as measurement data information 202, a display data label 11111 and a generation subject range 202c2.

Next, operations of the communication analysis apparatus 100 will be described.
Processes performed by the communication analysis apparatus 100 according to this embodiment are broadly classified into three procedures: a measurement procedure 1A; an analysis and synchronization procedure 1B; and an analysis result display procedure 1C. Hereafter, the above-mentioned procedures 1A to 1C will be described.

First, the measurement procedure 1A will be described.
The communication means 101 is connected to a wired or wireless transmission path. The communication means 101 acquires a communication message 201a transmitted or received by an apparatus connected to the transmission path one after another, records a message acquisition time 202a1 that is original measurement data acquisition time information indicating the time when the communication message 201a has been acquired, and notifies the division organization information-added communication message storage means 103 of the communication message 201a and message acquisition time 202a1.

The communication analysis apparatus 100 may include one or more communication means 101 and each communication means 101 may acquire a communication message 201a adhering to a different communication protocol.

The waveform measuring means 102 is connected to a wired or wireless transmission path. The waveform measuring means 102 acquires a waveform signal 201b transmitted or received by an apparatus connected to the transmission path one after another at an arbitrary sampling rate 202b2, records a waveform acquisition time 202b1 that is original measurement data acquisition time information indicating the time when the waveform signal 201b has been acquired, and notifies the division organization information-added waveform signal storage means 104 of the waveform signal 201b, waveform acquisition time 202b1, and sampling rate 202b2.

The communication analysis apparatus 100 may include one or more waveform measuring means 102 and each waveform measuring means 102 may acquire a waveform signal 201b having a different sampling rate 202b2.

Each time the division organization information-added communication message storage means 103 is notified of a communication message 201a as division measurement data by the communication means 101, it newly generates a division organization information-added communication message 200a, incorporates the communication message 201a as the measurement data 201 and message acquisition time 202a1 as measurement data information 202 into the division organization information-added communication messages 200a, and then stores the division organization information-added communication messages 200a.

Each time the division organization information-added waveform signal storage means 104 is notified of a waveform signal 201b as division measurement data by the waveform measuring means 102, it newly generates a division organization information-added waveform signal 200b, stores the waveform signal 201b as measurement data 201, stores the waveform acquisition time 202b1 and sampling rate 202b2 as measurement data information 202, and then memorizes the division organization information-added waveform signal 200b.

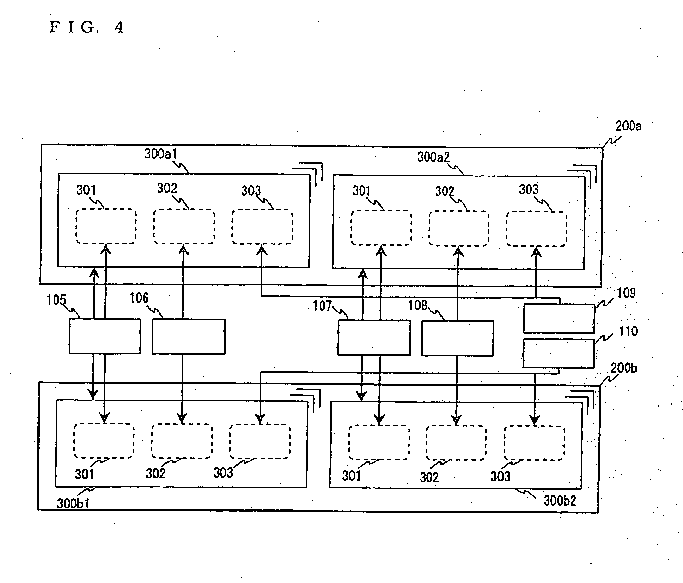

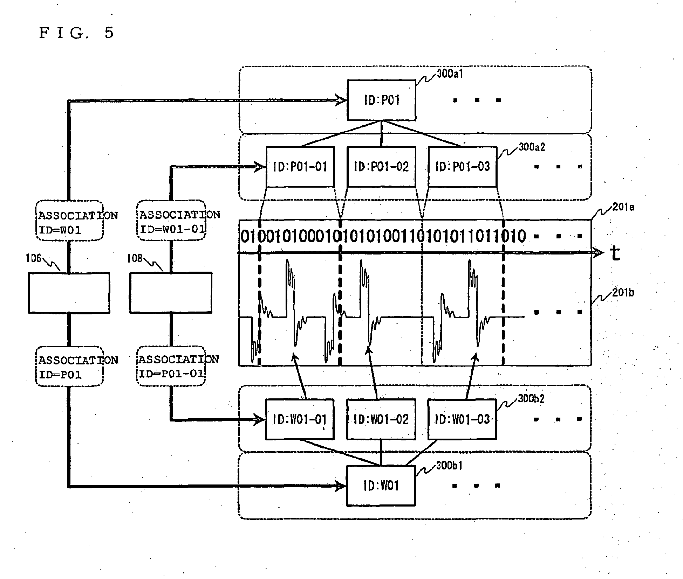

Fig. 4 is diagram showing operations in the analysis and synchronization procedure 1B according to the first embodiment of the present invention. Fig. 5 is a diagram showing a method for associating communication message 201a and a waveform signal 201b with each other using division organization information 300 according to the first embodiment of the present invention.
Hereafter, the analysis and synchronization procedure 1B will be described.

The division organization information-added communication message storage means 103 notifies the communication unit division organization information addition means 105 of a division organization information-added communication message 200a where a communication unit extraction flag 203a1 is not set, among the stored division organization information-added communication messages 200a.
The division organization information-added communication message storage means 103 notifies the communication unit synchronization determination means 106 of a division organization information-added communication message 200a where a communication unit extraction flag 203a1 is set and a communication unit synchronization determination flag 203a2 is not set.
The division organization information-added communication message storage means 103 notifies the modulation unit division organization information addition means 107 of a division organization information-added communication message 200a where a communication unit synchronization determination flag 203a2 is set and a modulation unit extraction flag 203a3 is not set.
The division organization information-added communication message storage means 103 notifies the modulation unit synchronization determination means 108 of a division organization information-added communication message 200a where a modulation unit extraction flag 203a3 is set and a communication analysis flag 203a4 is not set.
The division organization information-added communication message storage means 103 notifies the communication analysis means 109 of a division organization information-added communication message 200a where a modulation unit synchronization determination flag 203a4 is set and a communication analysis flag 203a5 is not set.
It is assumed that each time the above-mentioned flags are set by performing an operation to be described later, the corresponding above-mentioned means is notified of a division organization information-added communication message 200a.

The division organization information-added waveform signal storage means 104 notifies the communication unit division organization information addition means 105 of a division organization information-added waveform signal 200b where a communication unit extraction flag 203b1 is not set, among the stored division organization information-added waveform signals 200b.
The division organization information-added waveform signal storage means 104 notifies the communication unit synchronization determination means 106 of a division organization information-added waveform signal 200b where a communication unit extraction flag 203b1 is set and a communication unit synchronization determination flag 203b2 is not set.
The division organization information-added waveform signal storage means 104 notifies the modulation unit division organization information addition means 107 of a division organization information-added waveform signal 200b where a communication unit synchronization determination flag 203b2 is set and a modulation unit extraction flag 203b3 is not set.
The division organization information-added waveform signal storage means 104 notifies the modulation unit synchronization determination means 108 of a division organization information-added waveform signal 200b where a modulation unit extraction flag 203b3 is set and a modulation unit synchronization determination flag 203b4 is not set.
The division organization information-added waveform signal storage means 104 notifies the waveform analysis means 110 of a division organization information-added waveform signal 200b where a modulation unit synchronization determination flag 203b4 is set and a waveform analysis flag 203b5 is not set.
It is assumed that each time the above-mentioned flags are set by performing an operation to be described later, the corresponding above-mentioned means is notified of a division organization information-added communication message 200a.

The communication unit division organization information addition means 105 sets the communication unit extraction flag 203a1 included in the notified division organization information-added communication message 200a and derives the start position and end position of the communication unit included in the communication message 201a and a communication protocol adhered to by the communication message 201a.
Each time the communication unit division organization information addition means 105 derives the start position and end position, it generates a message communication unit division organization information 300a1 and stores basic information 301.
Specifically, the communication unit division organization information addition means 105 generates a basic ID 3012 that is an ID (identification) unique to the message communication unit division organization information 300a1 and derives a start time corresponding to the start position and an end time corresponding to the end position on the basis of the message acquisition time 202a1.
The communication unit division organization information addition means 105 sets the communication unit for the division unit 3011 of the basic information 301, stores the generated basic ID 3012, stores the derived start position and end position in the division time, stores the derived start time and end time in the division time 3014, and stores the derived communication protocol in the measurement data type 3015.

As for the start position and end position, the communication unit division organization information addition means 105 may derive them from a downtime of the communication message 201a or may derive them by extracting a start bit and a stop bit.
As for the communication protocol, the communication unit division organization information addition means 105 may include a table for associating message header formats and communication protocols with each other and may derive the communication protocol from the table. Also, the communication analysis apparatus 100 may include a communication means 101 for each communication protocol and the communication unit division organization information addition means 105 may derive the communication protocol by distinguishing a communication means 101 that is the notification source of the communication message 201a.

The communication unit division organization information addition means 105 sets the communication unit extraction flag 203b1 included in the notified division organization information-added waveform signal 200b and derives the start position and end position of the communication unit from the waveform signal 201b.
Each time this start position and end position are extracted, the communication unit division organization information addition means 105 generates waveform communication unit division organization information 300b1 and stores basic information 301 included in the waveform communication unit division organization information 300b1.
Specifically, the communication unit division organization information addition means 105 generates an basic ID 3012 unique to the waveform communication unit division organization information 300b1 and derives a start time corresponding to the start position and an end time corresponding to the end position on the basis of the waveform acquisition time 202b1 and sampling rate 202b2.
Then, the communication unit division organization information addition means 105 sets the communication unit for the division unit 3011 of the basic information 301, stores the generated basic ID 3012, stores the derived start position and end position in the division position 3013, and stores the derived start time and end time in the division time 3014.

As for the start position and end position, the communication unit division organization information addition means 105 may have a level threshold and derive the start position and end position by comparing the level of the waveform signal 201b with the level threshold. Also, the communication unit division organization information addition means 105 may have a level change amount threshold and derive the start position and end position by comparing the level change amount of the waveform signal 201b with the level change amount threshold.

The communication unit synchronization determination means 106 extracts one piece of message communication unit division organization information 300a1 included in the notified division organization information-added communication message 200a and one piece of the waveform communication unit division organization information 300b1 included in the notified division organization information-added waveform signal 200b, and creates a set of the extracted pieces of information.
If the division time 3014 included in the extracted message communication unit division organization information 300a1 and the division time 3014 included in the extracted waveform communication unit division organization information 300b1 meet the communication unit synchronization determination condition 1061 to be described later, the communication unit synchronization determination means 106 stores each information's basic ID 3012 in the other information's association ID 3021, as shown in Fig. 5.
Also, the communication unit synchronization determination means 106 sets the communication unit synchronization determination flag 203a2 included in the division organization information-added communication messages 200a and the communication unit synchronization determination flag 203b2 included in the division organization information-added waveform signal 200b.
The communication unit synchronization determination means 106 repeatedly performs this process with respect to all sets of message communication unit division organization information 300a1 and waveform communication unit division organization information 300b1.

The above-mentioned communication unit synchronization determination condition 1061 may be, for example, "the difference between the division times 3014 is equal to or smaller than a threshold" or "a value obtained by adding an offset to the difference between the division times 3014 is equal to or smaller than a threshold."
The threshold may be a constant value, or different values may be set for communication protocols included in the division organization information-added communication message 200a.

The modulation unit division organization information addition means 107 sets the modulation unit extraction flag 203a3 included in the notified division organization information-added communication message 200a.
Then, the modulation unit division organization information addition means 107 derives the start position and end position and the start time and end time of the modulation unit included in the communication message 201a on the basis of the measurement data type 3015, division position 3013, and division time 3014 included in the message communication unit division organization information 300a1.

If the modulation unit division organization information addition means 107 succeeds in the derivation, it generates message modulation unit division organization information 300a2 and stores basic information 301.
Specifically, the modulation unit division organization information addition means 107 generates a basic ID 3012 unique to the message modulation unit division organization information 300a2 and stores the generated basic ID 3012, stores the start position and end position in the division position 3013, and stores the start time and end time in the division time 3014.
If the division position 3013 included in the message modulation unit division organization information 300a2 is included in the division position 3013 included in the message communication unit division organization information 300a1, the modulation unit division organization information addition means 107 copies the measurement data type 3015 included in the message communication unit division organization information 300a1 to the measurement data type 3015 included in the message modulation unit division organization information 300a2 so that the basic ID 3012 of the message modulation unit division organization information 300a2 becomes an ID that is cross-referential with the basic ID 3012 of the message communication unit division organization information 300a1.

As shown in Fig. 5, the above-mentioned cross-referential IDs may be realized, for example, by defining basic IDs 3012 as hierarchical IDs and incorporating the basic ID 3012 of the message communication unit division organization information 300a1 into the basic IDs 3012 of the pieces of message modulation unit division organization information 300a2. Also, the above-mentioned cross-referential IDs may be realized, for example, by defining basic IDs 3012 as numerical values having a digit unique to the division unit 3011 and giving an identical value to the respective digits where the division unit 3011 is the communication unit, of the basic ID 3012 included in the message communication unit division organization information 300a1 and the basic IDs 3012 included in the message modulation unit division organization information 300a2.

Also, the modulation unit division organization information addition means 107 sets the modulation unit extraction flag 203b3 included in the notified division organization information-added waveform signal 200b.
Then, the modulation unit division organization information addition means 107 derives the start position and end position and the start time and end time of the modulation unit included in the waveform signal 201b with respect to a piece of waveform communication unit division organization information 300b1 including an association ID 3021 among the pieces of waveform communication unit division organization information 300b1 included in the division organization information-added waveform signal 200b, on the basis of the measurement data type 3015 of a piece of message communication unit division organization information 300a1 having a basic ID 3012 stored in the association ID 3021 and on the basis of the division position 3013 and division time 3014 included in the piece of waveform communication unit division organization information 300b1.

If the modulation unit division organization information addition means 107 succeeds in the derivation, it generates waveform modulation unit division organization information 300b2 and stores basic information 301.
Specifically, the modulation unit division organization information addition means 107 generates a basic ID 3012 unique to the waveform modulation unit division organization information 300b2 and stores the basic ID 3012, stores the start position and end position in the division position 3013, and stores the start time and end time in the division time 3014.
If the division position included in the waveform modulation unit division organization information 300b2 is included in the division position included in the waveform communication unit division organization information 300b1, the modulation unit division organization information addition means 107 makes the basic ID 3012 of the waveform modulation unit division organization information 300b2 an ID that is cross-referential with the basic ID 3012 of the waveform communication unit division organization information 300b1.

As shown in Fig. 5, the above-mentioned cross-referential IDs may be realized, for example, by defining basic IDs 3012 as hierarchical IDs and incorporating the basic ID 3012 of the waveform communication unit division organization information 300b1 into the basic IDs 3012 of the pieces of the waveform modulation unit division organization information 300b2. Also, the above-mentioned cross-referential IDs may be realized, for example, by defining basic IDs 3012 as numerical values having a digit unique to the division unit and giving an identical value to the respective digits where the division unit is the communication unit, of the basic ID 3012 included in the waveform communication unit division organization information 300b1 and the basic IDs 3012 included in the waveform modulation unit division organization information 300b2.

The modulation unit synchronization determination means 108 extracts a piece of waveform communication unit division organization information 300b1 including, as an association ID 3021, the basic ID 3012 of a piece of message communication unit division organization information 300a1 included in the notified division organization information-added communication message 200a, from the notified division organization information-added waveform signal 200b.

If the modulation unit synchronization determination means 108 succeeds in the extraction, it extracts one piece of message modulation unit division organization information 300a2 referred to by the message communication unit division organization information 300a1 and one piece of message modulation unit division organization information 300a2 referred to by the extracted waveform communication unit division organization information 300b1, and creates a set of the extracted pieces of information.
If the division times 3014 included in the message modulation unit division organization information 300a2 and waveform modulation unit division organization information 300b2 forming this set meet the modulation unit synchronization determination condition 1081 to be described later, the modulation unit synchronization determination means 108 stores each information's basic ID 3012 in the other information's association ID 3021 as shown in Fig. 5, and sets a modulation unit synchronization determination flag 203a4 included in the division organization information-added communication message 200a and a modulation unit synchronization determination flag 203b4 included in the division organization information-added waveform signal 200b.
The modulation unit synchronization determination means 108 repeatedly performs this process with respect to all the pieces of message communication unit division organization information 300a1.

The above-mentioned modulation unit synchronization determination condition 1081 may be, for example, "the difference between the division times 3014 is equal to or smaller than a threshold" or "a value obtained by adding an offset to the difference between the division times 3014 is equal to or smaller than a threshold."
The threshold may be a constant value, or a different value may be set for the measurement data type 3015 included in each message communication unit division organization information 300a1.

The communication analysis means 109 sets a communication analysis flag 203a5 included in the notified division organization information-added communication message 200a and performs the following process with respect to all the communication analyzers 1091 included in the communication analysis means 109.
The communication analyzer label 10911 of a communication analyzer 1091 is a label unique to the communication analyzer 1091. The communication analysis subject 10912 contains the communication protocol of the communication analyzer 1091.

If the communication analysis subject 10912 included in a communication analyzer 1091 matches the measurement data type 3015 included in a piece of message communication unit division organization information 300a1 included in the notified division organization information-added communication message 200a, the communication analysis means 109 inputs a communication message 201a included in a range indicated by the division position 3013 of the piece of message communication unit division organization information 300a1, into the communication analyzer 1091.
Then, the communication analysis means 109 stores the output result of the communication analyzer 1091 in the analysis value 3032 of the message communication unit division organization information 300a1 and stores a unique communication analyzer label 10921 included in the communication analyzer 1091 in the analysis label 3031 of the message communication unit division organization information 300a1.

The waveform analysis means 110 sets a waveform analysis flag 203b5 included in the notified division organization information-added waveform signal 200b and performs the following process with respect to all the waveform analyzers 1101 included in the waveform analysis means 110.
The waveform analyzer label 11011 of a waveform analyzer 1101 is a label unique to the waveform analyzer 1101. The waveform analysis subject 11012 contains the communication protocol of the waveform analyzer 1101. Also, the waveform analysis unit 11013 contains information whether the analysis unit of the waveform analyzer 1101 is the communication unit or modulation unit.

The waveform analysis means 110 extracts a piece of waveform communication unit division organization information 300b1 that includes an association ID 3021 and where the measurement data type 3015 of a piece of message communication unit division organization information 300a1 having a basic ID 3012 stored in the association ID 3021 matches the waveform analysis subject 11012 included in a waveform analyzer 1101, among the pieces of waveform communication unit division organization information 300b1 included in the division organization information-added waveform signal 200b.

If the waveform analysis unit 11013 included in the above-mentioned waveform analyzer 1101 is the communication unit, the waveform analysis means 110 inputs a waveform signal 201b included in a range indicated by the division position 3013 included in the waveform communication unit division organization information 300b1, into a selected waveform analyzer 1101.
Then, the waveform analysis means 110 stores the output result of the waveform analyzer 1101 in the analysis value 3032 of the waveform communication unit division organization information 300b1 and stores the waveform analyzer label 11011 of the waveform analyzer 1101 in the analysis label 3031.

On the other hand, if the waveform analysis unit 11013 included in the above-mentioned waveform analyzer is the modulation unit, the waveform analysis means 110 inputs waveform signals 201b included in ranges indicated by the division positions 3013 included in all pieces of waveform modulation unit division organization information 300b2 referred to by the waveform communication unit division organization information 300b1, into a selected waveform analyzer 1101.
Then, the waveform analysis means 110 stores the output result of the waveform analyzer 1101 in the analysis value 3032 of the waveform modulation unit division organization information 300b2 and stores the waveform analyzer label 11011 of the waveform analyzer 1101 in the analysis label 3031.

Next, the analysis result display procedure 1C will be described.
Each time a generation subject range 202c2 to be described later is specified, the division organization information-added display data generation means 111 generates division organization information-added display data 200c with respect to all display data generators 1111 included in the division organization information-added display data generation means 111 and stores the display data label 11111 and generation subject range 202c2 of each display data generator 1111 in the corresponding division organization information-added display data 200c as measurement data information 202.

The division organization information-added display data generation means 111 has a display data generator 1111 at least for each of the above-mentioned communication analyzers 1091 and waveform analyzers 1101. The display data label 11111 of a waveform analyzer 1101 is a label unique to the corresponding display data generator 1111. The generation subject 11112 contains information indicating an analysis label 3031 corresponding to an analysis value 3032 convertible by the display data generator 1111. The generation unit 11113 contains information indicating whether a division unit 3011 convertible by the display data generator 1111 is the communication unit or modulation unit.

Also, the division organization information-added display data generation means 111 extracts a piece of division organization information-added communication messages 200a that is included in the generation subject range 202c2 and where a communication analysis flag 203a5 is set, from the division organization information-added communication message storage means 103.
Then, the division organization information-added display data generation means 111 extracts a piece of message communication unit division organization information 300a1 and a piece of message modulation unit division organization information 300a2 included in the extracted division organization information-added communication message 200a.
Also, the division organization information-added display data generation means 111 extracts, from the division organization information-added waveform signal storage means 104, a piece of waveform communication unit division organization information 300b1 indicated by a basic ID 3012 stored in the association ID 3021 of the extracted message communication unit division organization information 300a1 of the division organization information-added communication message 200a and a piece of waveform modulation unit division organization information 300b2 indicated by a basic ID 3012 stored in the association ID 3021 of the extracted message modulation unit division organization information 300a2 of the division organization information-added communication message 200a.
The division organization information-added display data generation means 111 performs the following process with respect to all of the extracted message communication unit division organization information 300a1, message modulation unit division organization information 300a2, waveform communication unit division organization information 300b1, and waveform modulation unit division organization information 300b2 (hereafter collectively referred to as "extracted division organization information 300").

The division organization information-added display data generation means 111 inputs the division organization information 300 into a display data generator 1111 having a generation unit 11113 matching the division unit 3011 of the extracted division organization information 300 and having a generation subject 11112 matching the analysis label 3031 of the extracted division organization information 300.

The display data generator 1111 generates display data 201c by converting an analysis value 3032 corresponding to the analysis label 3031 included in the inputted division organization information 300. Then, the display data generators 1111 stores, as measurement data 201, the generated display data 201c in division organization information-added display data 200c including the display data label 11111 of the display data generator 1111.

Each time the display data 201c is stored in the division organization information-added display data 200c by a display range number to be described later, the display data generators 1111 generate display division organization information 300c1 using the display range number as the division unit 3011, in the division organization information-added display data 200c. Then, the display data generators 1111 generate and store a basic ID 3012 unique to this display division organization information 300c1, store the start position and end position in the division position 3013, and stores, in the association ID 3021, all the basic IDs 3012 included in the inputted division organization information 300 that is the generation source of the display data 201c.

Also, each time the display data 201c is stored in the division organization information-added display data 200c by a selection range number to be described later, the display data generator 1111 generate selection division organization information 300c2 using the selection range number as the division unit 3011, in the division organization information-added display data 200c. Then, the display data generator 1111 generate and store a basic ID 3012 unique to this selection division organization information 300c2, store the start position and end position in the division position 3013, and store, in the association ID 3021, all the basic IDs 3012 included in the inputted division organization information 300 that is the generation source of the data for selection.

Also, if a division position 3013 included in the selection division organization information 300c2 is included in the division position 3013 included in the display division organization information 300c1, the basic ID 3012 of the selection division organization information 300c2 is considered as an ID that is cross-referential with the basic ID 3012 of the display division organization information 300c1.

The above-mentioned cross-referential IDs may be realized by defining basic ID 3012s as hierarchical IDs and incorporating the basic ID 3012 of the display division organization information 300c1 into the basic ID 3012 of the selection division organization information 300c2. Also, the above-mentioned cross-referential IDs may be realized by defining basic IDs 3012 as numerical values having a digit unique to the division unit 3011 and giving an identical value to the digits where the division unit 3011 is a display range number, of the basic ID 3012 of the display division organization information 300cl and the basic ID 3012 of the selection division organization information 300c2.

When the division organization information-added display data generation means 111 completes the process with respect to all of the extracted division organization information 300, it notifies the division organization information-added display data storage means 112 of the division organization information-added display data 200c.

The above-mentioned generation subject range 202c2 may be a time range or a list of basic IDs 3012 included in the division organization information 300.
Also, the generation subject range 202c2 may be specified automatically periodically or may be specified manually using an operation means.

The division organization information-added display data storage means 112 stores the notified division organization information-added display data 200c.

The display data specification means 113 specifies a display data label 11111 and notifies the association ID display data extraction means 114 of the display data label 11111, display range data that is display data 201c having a format generated by a display data generator 1111 having the display data label 11111 and that has a data width equal to that of a display range number included in the display data generator 1111, and selection data having a data width equal to that of a selection range number included in the display data generator 1111.

The association ID display data extraction means 114 refers to a piece of division organization information-added display data 200c having a display data label 11111 specified by the display data specification means 113 among pieces of division organization information-added display data 200c stored by the division organization information-added display data storage means 112, and performs the following process.

The association ID display data extraction means 114 extracts all other pieces of display division organization information 300c1 including, as association IDs 3021, one or more association IDs 3021 included in a piece of display division organization information 300c1 corresponding to the specified display range data, extracts display data 201c included in a range indicated by each of the extracted pieces of display division organization information 300c1, and notifies an analysis result display means 115 having the specified display data label 11111 of the extracted display data 201c as new display range data.

The association ID display data extraction means 114 extracts all other pieces of selection division organization information 300c2 including, as association IDs 3021, one or more association IDs 3021 included in a piece of selection division organization information 300c2 corresponding to the specified selection range data, extracts display data 201c included in a range indicated by a division position included in each of the extracted other pieces of selection division organization information 300c2, and notifies an analysis result display means 115 having the specified display data label 11111 of the extracted display data 201c as new selection range data.

The analysis result display means 115 displays the notified new display range data and displays the new selection data in such a manner that the new selection data is distinguished from other data, for example, in a highlighted manner.

As a highlighting method, the new selection data may be displayed using a remarkable color, the sizes of points or lines may be enlarged, or animation may be used.

As described above, in this embodiment, division organization information-added communication message 200a and a division organization information-added waveform signal 200b are generated, division organization information 300 where the division organization information-added communication message (200a) and division organization information-added waveform signal 200b are associated with each other is extracted, division organization information-added display data 200c is generated on the basis of the extracted division organization information 300, and the display data display data 201c corresponding to the display division organization information 300c1
or selection division organization information 300c2 is displayed. Thus, a communication message and a waveform signal can be analyzed in such a manner that the communication message and waveform signal are associated with each other.

Also, by specifying a generation subject range 202c2, display data 201c corresponding to the specified range is displayed. This allows analyzing a transmission path automatically. Therefore, a user can easily identify a cause of a transmission failure or a failure occurrence location so as to address the transmission failure even if the user does not have expertise or experience about communication protocols or waveform signals.
Also, the communication analysis apparatus 100 includes the multiple communication analysis means 109 and multiple waveform analysis means 110 so that one piece of data can be analyzed using the multiple analysis means. This allows analyzing a particular signal intensively from many fronts. Thus, it is expected that the accuracy and efficiency of analysis work will be improved.

### Second Embodiment

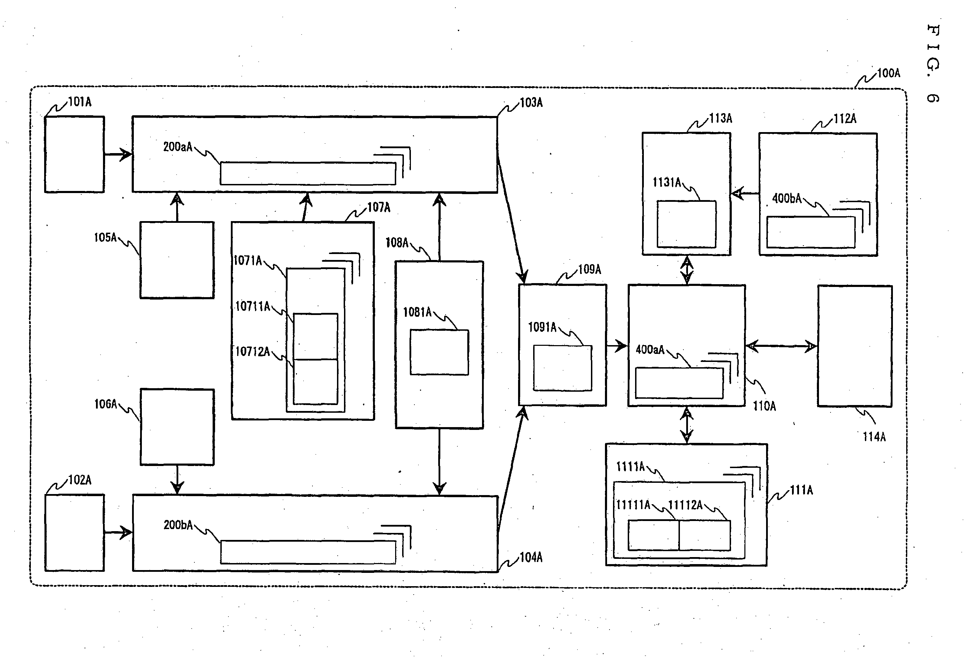

Fig. 6 is a block diagram showing a configuration of a communication analysis apparatus 100A according to a second embodiment of the present invention.
The communication analysis apparatus 100A includes a communication means 101A, a waveform measuring means 102A, a division organization information-added communication message storage means 103A, a division organization information-added waveform signal storage means 104A, a message division organization information addition means 105A, a waveform division organization information addition means 106A, a message analysis means 107A, a synchronization determination means 108A, an analysis waveform information generation means 109A, an analysis waveform information storage means 110A, a waveform characteristic amount calculation means 111A, an ideal waveform information storage means 112A, a communication state determination means 113A, and an analysis result display means 114A.

The division organization information-added communication message storage means 103A stores one or more division organization information-added communication messages 200aA. The division organization information-added waveform signal storage means 104A stores one or more division organization information-added waveform signals 200bA. The message analysis means 107A includes one or more message analyzers 1071A. The message analyzers 1071A include a message analyzer label 10711A and a message analysis subject 10712A. The synchronization determination means 108A has a synchronization determination condition 1081A. The analysis waveform information storage means 110A stores one or more pieces of analysis waveform information 400aA. The waveform characteristic amount calculation means 111A includes one or more characteristic amount calculators 1111A. The characteristic amount calculators 1111A include a calculator label 11111A and calculation subject data 11112A. The ideal waveform information storage means 112A stores one or more pieces of ideal waveform information 400bA.

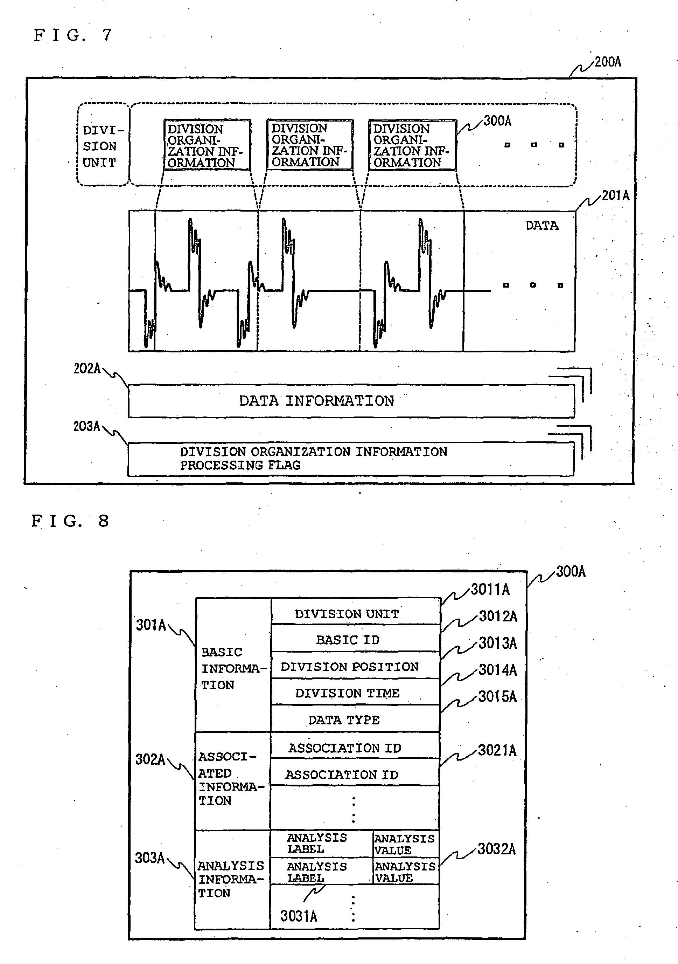

Fig. 7 is a diagram showing a configuration of division organization information-added data 200A.
The division organization information-added data 200A includes zero or more pieces of division organization information 300A, one piece of data 201A, zero or more pieces of data information 202A, and zero or more division organization information processing flags 203A.

Fig. 8 is a drawing showing a configuration of the division organization information 300A.
The division organization information 300A includes basic information 301A, analysis information 303A, and association information 302A.
The basic information 301A includes a division unit 3011A, a basic ID 3012A, a division position 3013A, a division time 3014A, and a data type 3015A. The association information 302A includes zero or more association IDs 3021A. The analysis information 303A includes zero or more sets of an analysis label 3031A and an analysis value 3032A.

Configurations of the division organization information-added communication message 200aA and division organization information-added waveform signal 200bA imitate a configuration of the division organization information-added data 200A.
Specifically, the division organization information-added communication message 200aA includes message division organization information 300aA as the division organization information 300A, a communication message 201aA as the data 201A, a message acquisition time 202a1A as the data information 202A, and a communication unit extraction flag 203a1A, a message analysis flag 203a2A, and a synchronization determination flag 203a3A as division organization information processing flags 203A.
The division organization information-added waveform signal 200bA includes waveform division organization information 300bA as the division organization information 300A, a waveform signal 201bA as the data 201A, a waveform acquisition time 202b1A and a sampling rate 202b2A as the data information 202A, and a communication unit extraction flag 203b1A and a synchronization determination flag 203b2A as division organization information processing flags 203A.

Next, operations of the communication analysis apparatus 100A will be described.
Processes performed by the communication analysis apparatus 100A are broadly classified into four procedures: a communication message acquisition and analysis procedure 1A; a waveform signal acquisition and synchronization procedure 1B; an analysis waveform information generation procedure 1C; and a communication state determination procedure 1D. Hereafter, the above-mentioned procedures 1A to 1D will be described.

The message acquisition and analysis procedure 1A will be described.
The communication means 101A is connected to a wired or wireless transmission path. The communication means 101 acquires a communication message 201aA transmitted or received by an apparatus connected to the transmission path, records a message acquisition time 202a1A indicating the time when the communication message 201aA has been acquired, and notifies the division organization information-added communication message storage means 103A of the communication message 201aA and message acquisition time 202a1A.

The communication analysis apparatus 100A may include one or more communication means 101A and each communication means 101A may acquire the communication message 201aA adhering to a different communication protocol.

Each time the division organization information-added communication message storage means 103A is notified of the communication message 201aA, it newly generates the division organization information-added communication message 200aA, stores and memorizes the communication message 201aA and message acquisition time 202a1A.

Also, the division organization information-added communication message storage means 103A notifies the message division organization information addition means 105A of a division organization information-added communication message 200aA where the communication unit extraction flag 203a1A is not set, among the division organization information-added communication messages 200aA.
The division organization information-added communication message storage means 103A notifies the message analysis means 107A of a division organization information-added communication message 200aA where the communication unit extraction flag 203a1A is set and the message analysis flag 203a2A is not set. The division organization information-added communication message storage means 103 notifies the synchronization determination means 108A of a division organization information-added communication message 200aA where the message analysis flag 203a2A is set and the synchronization determination flag 203a3A is not set. The division organization information-added communication message storage means 103A notifies the analysis waveform information generation means 109A of a division organization information-added communication message 200aA where the synchronization determination flag 203a3A is set.

The message division organization information addition means 105A sets the communication unit extraction flag 203a1A of the division organization information-added communication message 200aA that is notified of by the division organization information-added communication message storage means 103A and where the communication unit extraction flag 203a1A is not set, so as to derive the start position and end position of the communication unit included in the communication message 201aA and a communication protocol adhered to by the communication message 201aA. Each time the start position and end position are derived, the message division organization information addition means 105A generates the message division organization information 300aA and stores the basic information 301A. Specifically, the message division organization information addition means 105A generates the basic ID 3012A unique to the message division organization information 300aA, derives a start time corresponding to the start position and an end time corresponding to the end position on the basis of the message acquisition time 202a1A, stores the basic ID 3012A, stores the start position and end position in the division position 3013A, stores the start time and end time in the division time 3014A, and stores the communication protocol in the data type 3015A.

As for the start position and end position, the message division organization information addition means 105A may derive these positions from a downtime of the communication message 201aA or by extracting a start bit and a stop bit. As for the communication protocol, the message division organization information addition means 105A may include a table for associating communication message header formats and communication protocols with each other and may derive the communication protocol by referring to the table. Also, the communication analysis apparatus 100A may include a communication means 101A for each communication protocol and the message division organization information addition means 105A may derive the communication protocol by distinguishing a communication means 101A that is the source of the communication message 201aA.

The message analysis means 107A sets the message analysis flag 203a2A included in the division organization information-added communication message 200aA that is notified by the division organization information-added communication message storage means 103A and where the communication unit extraction flag 203a1A is set and the message analysis flag 203a2A is not set, and performs the following process with respect to all the message analyzers 1071A included in the message analysis means 107A.
If the message analysis subject 10712A of the message analyzer 1071A matches the data type 3015A of the message division organization information 300aA, the message analysis means 107A inputs, into the message analyzer 1071A, a communication message 201aA included in a range indicated by the start position and end position stored in the division position 3013A of the message division organization information 300aA, stores the output result of the message analyzer 1071A in the analysis value 3032A of the message division organization information 300aA, and stores the message analyzer label 10711A of the message analyzer 1071A in the analysis label 3031A.

The message analyzer 1071A may be an address analyzer for deriving the destination address and source address of the communication message or may be a CRC error determination apparatus for deriving a CRC error of the communication message.

The waveform signal acquisition and synchronization procedure 1B will be described.
The waveform measuring means 102A is connected to a wired or wireless transmission path. The communication means 101 acquires a waveform signal 201bA transmitted or received by an apparatus connected to the transmission path at an arbitrary sampling rate 202b2A one after another, records a waveform acquisition time 202b1A indicating the time when the waveform signal 201bA has been acquired, and notifies the division organization information-added waveform signal storage means 104A of the waveform signal 201bA, waveform acquisition time 202b1A, and sampling rate 202b2A.

The communication analysis apparatus 100A may include one or more waveform measuring means 102A and each waveform measuring means 102A may acquire the waveform signal 201bA having the different sampling rate 202b2A.

Each time the division organization information-added waveform signal storage means 104A is notified of the waveform signal 201bA, it newly generates the division organization information-added waveform signal 200bA, and stores and memorizes the waveform acquisition time 202b1A, waveform acquisition time 202b1A, and sampling rate 202b2A.

Also, the division organization information-added waveform signal storage means 104A notifies the waveform division organization information addition means 106A of a division organization information-added waveform signal 200bA where the communication unit extraction flag 203b1A is not set, among the division organization information-added waveform signals 200bA, notifies the synchronization determination means 108A of a division organization information-added waveform signal 200bA where the communication unit extraction flag 203b1A is set, and notifies the analysis waveform information generation means 109A of a division organization information-added waveform signal 200bA where the synchronization determination flag 203b2A is set.

The waveform division organization information addition means 106A sets the communication unit extraction flag 203b1A of the division organization information-added waveform signal 200bA that is notified by the division organization information-added communication message storage means 103A and where the communication unit extraction flag 203b1A is not set, and derives the start position and end position of the communication unit from the waveform signal 201bA. Each time the start position and end position are extracted, the waveform division organization information addition means 106A generates the waveform division organization information 300bA and stores the basic information 301A included in the waveform division organization information 300bA. Specifically, the waveform division organization information addition means 106A generates the basic ID 3012A unique to the waveform division organization information 300bA, derives the start time corresponding to the start position and the end time corresponding to the end position on the basis of the waveform acquisition time 202b1A and sampling rate 202b2A, sets the communication unit for the division unit 3011A, stores the basic ID 3012A, stores the start position and end position in the division position 3013A, and stores the start time and end time in the division time 3014A.

As for the start position and end position, the waveform division organization information addition means 106A may have a level threshold and derive these positions by comparing the level of the waveform signal 201bA with the level threshold. Also, the message division organization information addition means 105A may have a level change amount threshold and derive the start position and end position by comparing the level change amount of the waveform signal 201bA with the level change amount threshold.

The synchronization determination means 108A extracts one of the pieces of message division organization information 300aA included in the division organization information-added communication message 200aA that is notified by the division organization information-added communication message storage means 103A and where the synchronization determination flag 203a3A is not set, extracts one of the pieces of waveform division organization information 300bA included in the division organization information-added waveform signal 200bA that is notified by the division organization information-added waveform signal storage means 104A and where the synchronization determination flag 203b2A is not set, and creates a set of the extracted pieces of information. If the division times 3014A of the message division organization information 300aA and the waveform division organization information 300bA meet the synchronization determination condition 1081, the synchronization determination means 108A stores each information's basic ID 3012 in the other information's association ID 3021A, and sets the modulation unit extraction flag 203a3 included in the division organization information-added communication message 200aA and the synchronization determination flag 203b2A included in the division organization information-added waveform signal 200bA. The synchronization determination means 108A repeatedly performs this process with respect to all sets of message division organization information 300aA and waveform division organization information 300bA.

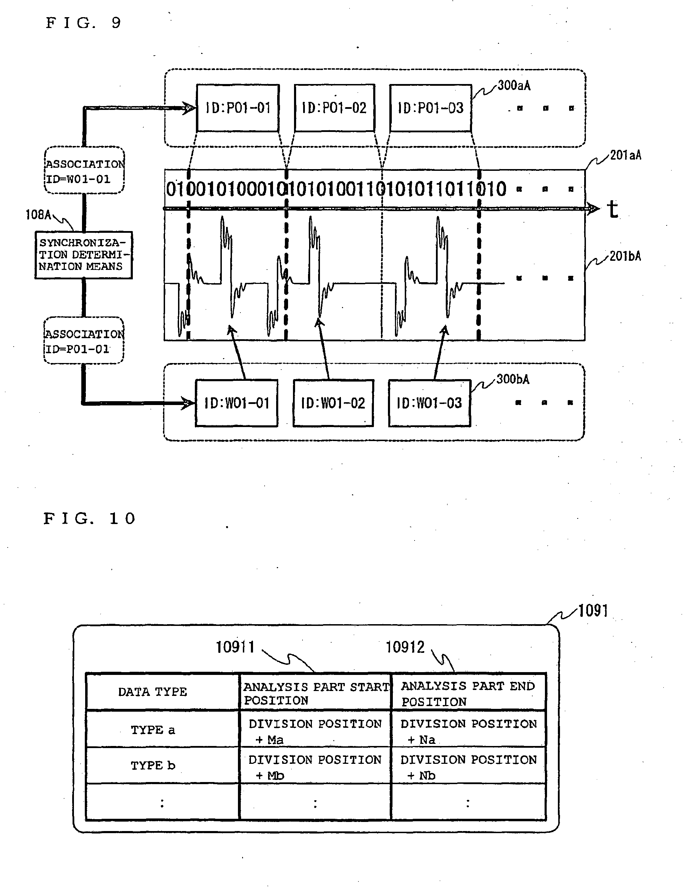

This aspect is shown in Fig. 9. The association between a communication message 201aA and a waveform signal 201bA using division organization information 300A will be described specifically using Fig. 9.
The synchronization determination means 108A extracts one piece of message division organization information 300aA included in the division organization information-added communication message 200aA that is notified by the division organization information-added communication message storage means 103A and where a synchronization determination flag 203a3A is not set and one piece of waveform division organization information 300bA included in the division organization information-added waveform signal 200bA that is notified by the division organization information-added waveform signal storage means 104A and where the synchronization determination flag 203b2A is not set, and creates a set of the extracted pieces of information. If the division times 3014A of the message division organization information 300aA and the waveform division organization information 300bA meet the synchronization determination condition 1081, the synchronization determination means 108A stores the basic ID 3012A = P01-01 of the message division organization information 300aA in the association ID 3021A of the waveform division organization information 300bA, and stores the basic ID 3012A = W01-01 of the division organization information 300bA in the association ID 3021A of the division organization information 300aA.
Subsequently, as such, if the division times 3014A of the message division organization information 300aA and the waveform division organization information 300bA meet the synchronization determination condition 1081A, the synchronization determination means 108A stores the basic ID 3012A = P01-02 of the message division organization information 300aA in the association ID 3021A of the waveform division organization information 300bA, and stores the basic ID 3012A = W01-02 of the division organization information 300bA in the association ID 3021A of the division organization information 300aA.
Subsequently, as such, if the division times 3014A of the message division organization information 300aA and the waveform division organization information 300bA meet the synchronization determination condition 1081A, the synchronization determination means 108A stores the basic ID 3012A = P01-03 of the message division organization information 300aA in the association ID 3021A of the waveform division organization information 300bA, and stores the basic ID 3012A = W01-03 of the division organization information 300bA in the association ID 3021A of the division organization information 300aA.
Hereafter, the same operations will repeatedly be performed.

The synchronization determination condition 1081A may be, for example, "the difference between the division times is equal to or smaller than a threshold" or "a value obtained by adding an offset to the difference between the division times is equal to or smaller than a threshold." The threshold may be a constant value, or a different value may be set for each of the communication protocols included in the division organization information-added communication message 200aA.

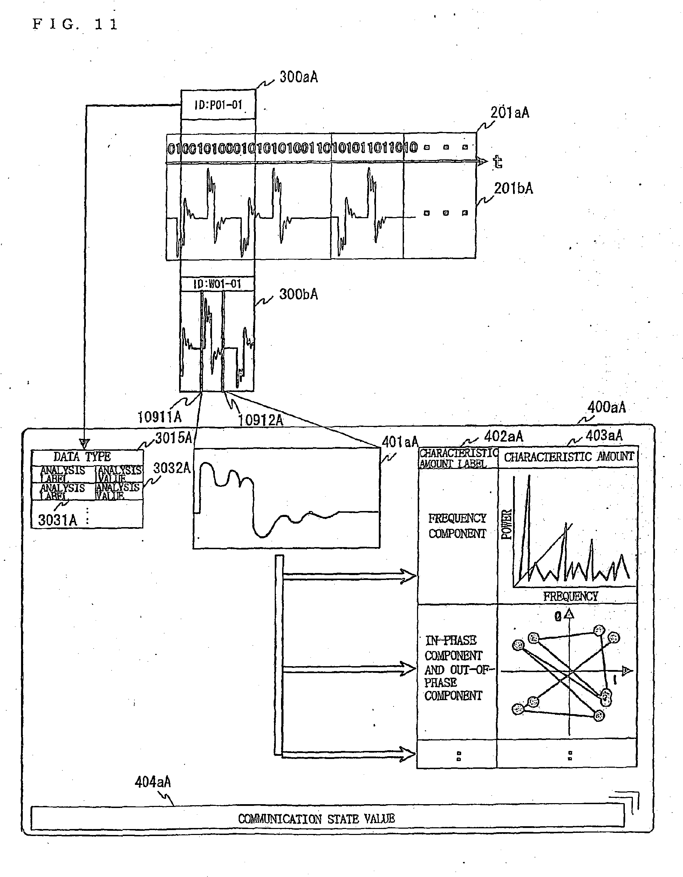

The analysis waveform information generation procedure 1C will be described.
The analysis waveform information generation means 109A refers to the message division organization information 300aA that is notified by the division organization information-added waveform signal storage means 104A and includes, as the basic ID 3012A, the association ID 3021A of the waveform division organization information 300bA included in the division organization information-added waveform signal 200bA, so as to acquire a data type 3015A, an analysis label 3031A, and an analysis value 3032A. Subsequently, the analysis waveform information generation means 109A acquires an analysis part start position and an analysis part end position by referring to an analysis part determination table 1091A shown in Fig. 10 using the data type 3015A and the division position 3013A included in the waveform division organization information 300bA as index keys for search, and extracts, as an analysis part waveform signal 401aA, a waveform signal included in a range specified by the analysis part start position and the analysis part end position. Data included in the analysis part determination table 1091A may be set when a system is introduced. Also, data determined by accumulating a waveform signal obtained on the basis of an evaluation test conducted before a system is introduced and then obtaining statistics with respect to the accumulated waveform signals may be set. Then, each time the analysis waveform information generation means 109A extracts an analysis part waveform signal 401aA, it generates analysis waveform information 400aA as shown in Fig. 11, stores the analysis part waveform signal 401aA, data type 3015A, analysis waveform information 3031A, and analysis value 3032A in the analysis waveform information 400aA, and notifies the analysis waveform information storage means 110A of the analysis waveform information 400aA.

The analysis waveform information storage means 110A notifies the waveform characteristic amount calculation means 111A of a piece of analysis waveform information 400aA where a characteristic amount calculation flag is not set, among the pieces of analysis waveform information 400aA notified by the analysis waveform information generation means 109A, and notifies the communication state determination means 113A of a piece of analysis waveform information 400aA where a characteristic amount calculation flag is set and a communication state determination flag is not set.

The waveform characteristic amount calculation means 111A sets a characteristic amount calculation flag included in a piece of analysis waveform information 400aA that is notified by the analysis waveform information storage means 110A and where the characteristic amount calculation flag is not set, and performs the following process with respect to all the characteristic amount calculators 1111A included in the waveform characteristic amount calculation means 111A.
The waveform characteristic amount calculation means 111A selects the data type 3015A of the analysis waveform information 400aA and calculation subject data 11112a of the characteristic amount calculator 1111A that are matched.
The waveform characteristic amount calculation means 111A inputs, into the selected characteristic amount calculator 1111A, the analysis part waveform signal 401aA included in the analysis waveform information 400aA, stores the output result of the characteristic amount calculator 1111A in the characteristic amount 403aA of the analysis waveform information 400aA, and stores the calculator label 11111A of the characteristic amount calculator 1111A in the characteristic amount 402aA.

One of the characteristic amount calculators 1111A may be a Fourier transformer for deriving a frequency component of a waveform signal, an I-Q calculator for deriving an in-phase component and an out-of-phase component of a waveform signal, or an MER calculator for deriving fluctuation amounts of the in-phase component and out-of-phase component.

The communication state determination procedure 1D will be described.
The communication state determination means 113A sets a state determination flag included in analysis waveform information that is notified by the analysis waveform information storage means 110A and where a characteristic amount calculation flag is set and the communication state determination flag is not set, and acquires ideal waveform information 400bA including the data type 3015A of the analysis waveform information 400aA from the ideal waveform information storage means 112A.
The communication state determination means 113A compares the analysis waveform information 400aA with an analysis part waveform signal included in the analysis waveform information 400aA and a characteristic amount so as to obtain a comparison value. Also, the communication state determination means 113A inputs the comparison value into the communication state determination table 1131A so as to obtain a communication state value 404aA, and stores the obtained communication state value 404aA in the analysis waveform information 400aA.

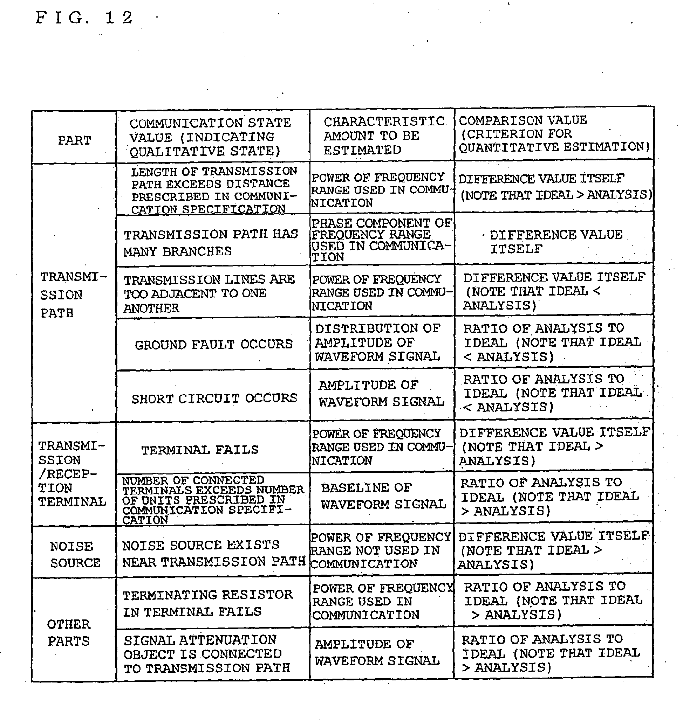

The comparison value of the analysis part waveform signal may be the largest amplitude value or a difference between average values. If the characteristic amount is a frequency component, the comparison value of the characteristic amount may be a difference between power of particular frequencies. If the characteristic amount is an in-phase component and an out-of-phase component, the comparison value may be a difference between amplitude distributions or a difference between phase distributions.
The communication state value may be the aged deterioration state of a transmission/reception terminal, the name of a failure part, the length of a transmission path between transmission/reception terminals, the aged deterioration state of the transmission path, the number of terminals connected to the whole transmission path, or the name of a noise source that adds noise to the waveform signal 201bA. The contents of these quantitative estimations are shown in Fig. 12.

The analysis result display means 114A acquires, from the analysis waveform information storage means 110A, the analysis waveform information 400aA specified automatically or in accordance with a manual instruction made by a worker. If a state determination flag of the analysis waveform information 400aA is set, the analysis result display means 114A displays the contents of the state determination flag.

### Industrial Applicability

Among usage examples of the present invention is a communication abnormality analysis tool of a communication network of such as an air-conditioning system of a building. The following are the claims of the parent application as filed and are included as part of the description of the present application.
1. A communication analysis apparatus for analyzing data acquired from a transmission path of a communication network, the communication analysis apparatus comprising
   division organization information addition means for adding division organization information including division unit information which defines the predetermined lengths and division position information which is information about start positions and end positions of the division data in the data, to a plurality of division data, which are obtained by dividing the data into predetermined lengths.
2. The communication analysis apparatus of Claim 1, wherein
   when the predetermined lengths are time lengths, the division organization information addition means adds, as the division position information, information indicating start time and end time of the division data.
3. The communication analysis apparatus of Claim 1 or 2, wherein
   the division organization information addition means creates a basic ID unique to each piece of division organization information and adds the division organization information having the basic ID.
4. The communication analysis apparatus of any one of Claims 1 to 3, wherein
   one or more basic IDs are set in a piece of the division organization information as association IDs, the one or more basic IDs being basic IDs of pieces of division organization information other than the piece of division organization information, and each indicating that the division data have a predetermined association with one another.
5. The communication analysis apparatus of Claim 3 or 4, wherein
   the division organization information addition means defines a hierarchical relation between the pieces of division organization information in accordance with sizes of the predetermined lengths, and
   when the division data corresponding to a piece of division organization information located at a higher level of hierarchy includes the division data corresponding to a piece of the division organization information located at a lower level of hierarchy, the division organization information addition means creates the basic IDs indicating that the piece of division organization information located at a higher level of hierarchy and the piece of division organization information located at a lower level of hierarchy can be cross-referential.
6. The communication analysis apparatus of Claim 5; wherein the division organization information addition means creates the cross-referential basic IDs by incorporating the basic ID of the piece of division organization information located at a higher level of hierarchy into a basic ID of the piece of division organization information located at a lower level of hierarchy.
7. The communication analysis apparatus of any one of Claims 1 to 6, wherein
   the division data are communication messages.
8. The communication analysis apparatus of Claim 7, wherein
   the division organization information addition means adds, to the division data, the division organization information where the division unit information is a communication unit, as message communication unit division organization information (300a1).
9. The communication analysis apparatus of Claim 8, wherein
   the message communication unit division organization information (300a1) includes information about a communication protocol conformed to by the division data.
10. The communication analysis apparatus of any one of Claims 7 to 9, wherein
   the division organization information addition means adds, to the division data, the division organization information where the division unit information is a modulation unit, as message modulation unit division organization information (300a2).
11. The communication analysis apparatus of any one of Claims 1 to 6, wherein
   the division data are waveform signals.
12. The communication analysis apparatus of Claim 11, wherein
   the division organization information addition means adds, to the division data, the division organization information where the division unit is a communication unit, as waveform communication unit division organization information (300b1).
13. The communication analysis apparatus of Claim 11 or 12, wherein the division organization information addition means adds, to the division data, the division organization information where the division unit is a modulation unit, as waveform modulation unit division organization information (300b2).
14. The communication analysis apparatus of any one of Claims 1 to 13, comprising
   division organization information-added data generation means for generating division organization information-added data including the data as the original data.
15. The communication analysis apparatus of Claim 14, wherein
   the division organization information-added data are generated by adding the division organization information from the division organization information addition means to each of division data obtained by dividing the original data into the predetermined lengths.
16. The communication analysis apparatus of Claim 14 or 15, wherein
   the division organization information-added data includes data information, and
   the data information includes original data acquisition time information indicating the time when the original data has been acquired.
17. The communication analysis apparatus of any one of Claims 14 to 16, wherein
   the division organization information-added data generation means generates the division organization information-added data where the original data is the original communication message and the division data are division communication messages, as a division organization information-added communication message (200a), and
   the division organization information-added communication message (200a) is generated by adding, as the division organization information, message communication unit division organization information (300a1) according to Claim 8 and/or message modulation unit division organization information (300a2) of Claim 10.
18. The communication analysis apparatus of any one of Claims 14 to 17, wherein
   the division organization information-added data generation means generates the division organization information-added data where the original data is original waveform signals and the division data are division waveform signals, as a division organization information-added waveform signal (200b), and
   the division organization information-added waveform signal (200b) is generated by adding, as the division organization information, waveform communication unit division organization information (300b1) according to Claim 12 and/or waveform modulation unit division organization information (300b2) according to Claim 13.
19. The communication analysis apparatus of Claims 18, wherein
   the data information includes information indicating a sampling rate of the original waveform signal.
20. A communication analysis apparatus comprising
   data synchronization means including:
   division organization information-added communication message storage means (103) for storing one or more division organization information-added communication messages (200a) according to Claim 17 with the added message communication unit division organization information(300a1) according to Claim 8,
   division organization information-added waveform signal storage means (104) for storing one or more division organization information-added waveform signals (200b) according to Claim 18 with the added waveform communication unit division organization information (300b1) according to Claim 12 and
   synchronization determination means having one or more synchronization determination conditions, wherein
   when the message communication unit division organization information (300a1) and the waveform communication unit division organization information (300b1) meet the synchronization determination condition, the synchronization determination means sets the basic ID of the waveform communication unit division organization information (300b1) as the association ID of the message communication unit division organization information (300a1), and sets the basic ID of the message communication unit division organization information (300a1) as the association ID of the waveform communication unit division organization information (300b1).
21. The communication analysis apparatus of Claim 20, wherein
   the division organization information-added communication message storage means (103) stores the one or more division organization information-added communication messages (200a) with the added message modulation unit division organization information (300a2) according to Claim 10,

   the division organization information-added waveform signal storage means (104) stores the one or more division organization information-added waveform signals (200b) with the added waveform modulation unit division organization information (300b2) according to Claim 13,
   when the message modulation unit division organization information (300a2) and the waveform modulation unit division organization information (300b2) meet the synchronization determination condition, the synchronization determination means sets the basic ID of the waveform modulation unit division organization information (300b2) as the association ID of the message modulation unit division organization information (300a2) and sets the basic ID of the message modulation unit division organization information (300a2) as the association ID of the waveform modulation unit division organization information (300b2).
22. The communication analysis apparatus of Claim 21, wherein
   the message communication unit division organization information (300a1), the waveform communication unit division organization information (300b1), the message modulation unit division organization information (300a2), and the waveform modulation unit division organization information (300b2) include information indicating start time and end time of the division data, and
   the synchronization determination means uses whether both a difference in the start time and a difference in the end time are equal to or smaller than a predetermined time error threshold, as the synchronization determination condition.
23. The communication analysis apparatus of any one of Claims 20 to 22, comprising:
   communication means for acquiring a communication message one after another and notifying the division organization information-added communication message storage means (103) of the acquired communication message; and
   waveform measuring means for acquiring a waveform signal one after another and notifying the division organization information-added waveform signal storage means (104) of the acquired waveform signal, wherein
   each time when notification of the communication message is provided, the division organization information-added communication message storage means (103) generates the division organization information-added communication messages (200a) and stores the communication message, and
   each time when notification of the waveform signal is provided, the division organization information-added waveform signal storage means (104) generates the division organization information-added communication messages (200a) and stores the waveform signal.
24. A communication analysis apparatus for analyzing data acquired from a transmission path of a communication network, the communication analysis apparatus comprising
   signal analysis means including one or more analyzers having one or more analysis conditions, wherein
   the signal analysis means receives input of division data, which are obtained by dividing the data into predetermined lengths and have division organization information according to the division data, and
   the analyzers select the division data meeting the analysis conditions and analyze the selected division data.
25. The communication analysis apparatus of Claim 24, wherein the analyzers store, in the division organization information, information indicating an analysis result of the division data.
26. The communication analysis apparatus of Claim 24 or 25, wherein
   the analyzers use whether a communication protocol conformed to by the division data matches a communication protocol conformed to by the analyzers, as the analysis condition.
27. The communication analysis apparatus of any one of Claims 24 to 26, wherein
   the analyzers use information for defining the predetermined lengths included in the division organization information as the analysis condition.
28. The communication analysis apparatus of any one of Claims 24 to 27, wherein
   the signal analysis means includes, as the analyzers, one or more waveform analyzers for analyzing the division data where the data is a waveform signal, and
   the waveform analyzers select a waveform signal of the division data meeting the analysis conditions on the basis of the division organization information and analyze the selected waveform signal.
29. The communication analysis apparatus of Claim 28, wherein
   the signal analysis means includes, as the waveform analyzer, at least one of a Fourier transformer for deriving a frequency component of the waveform signal, a spectrum calculator for calculating a power spectrum of the waveform signal, an I-Q calculator for calculating an in-phase component and an out-of-phase component of the waveform signal, an MER calculator for calculating an MER of the waveform signal, and a disturbance diagnostic apparatus for inferring a disturbance factor of the waveform signal.
30. The communication analysis apparatus Claim 28 or 29, wherein
   the signal analysis means receives input of a division organization information-added waveform signal (200b) according to Claim 18 or 20, and
   the waveform analyzers select the division organization information-added waveform signal (200b) meeting the analysis conditions, on the basis of waveform communication unit division organization information (300b1) according to Claim 12 added to the division organization information-added waveform signal (200b) or on the basis of waveform modulation unit division organization information (300b2) according to Claim 13 added to the division organization information-added waveform signal (200b), analyzes the division waveform signal of the selected division organization information-added waveform signal (200b), and stores a result of the analysis in the waveform communication unit division organization information (300b1) or the waveform modulation unit division organization information (300b2).
31. The communication analysis apparatus of Claim 30, wherein
   the analyzers use information about the communication protocol of the message communication unit division organization information (300a1) having, as the basic ID, the association ID of the waveform communication unit division organization information (300b1) set by the data synchronization means according to any one of Claims 20 to 23, as a communication protocol conformed to by the division waveform signal of the division organization information-added waveform signal (200b) with the added waveform communication unit division organization information (300b1).
32. The communication analysis apparatus of Claim 31, comprising division organization information addition means according to Claim 12 or 13, wherein
   the division organization information addition means adds, to the division organization information-added waveform signal (200b), the waveform communication unit division organization information (300b1) including information about a communication protocol conformed to by the division waveform signal or the waveform modulation unit division organization information (300b2).
33. The communication analysis apparatus of any one of Claims 24 to 27, wherein
   the signal analysis means includes, as the analyzers, one or more communication analyzers for analyzing the division data where the data is a communication message, and
   the communication analyzers select a communication message that is the division data meeting the analysis conditions, on the basis of the division organization information and analyze the selected communication message.
34. The communication analysis apparatus of Claim 33, wherein
   the signal analysis means includes, as the communication analyzer, at least one of an address analyzer for deriving a destination address and a source address of the communication message and a CRC error determination apparatus for deriving a CRC error of the communication message.
35. The communication analysis apparatus of Claim 33 or 34, wherein the signal analysis means receives input of a division organization information-added communication message (200a) according to Claim 17 or 20, and
   the communication analyzers select the division organization information-added communication message (200a) meeting the analysis conditions on the basis of message communication unit division organization information (300a1) according to Claim 8 added to the division organization information-added communication message (200a) or on the basis of message modulation unit division organization information (300a2) according to Claim 10 added to the division organization information-added communication message (200a), analyzes the division communication message of the selected division organization information-added communication message (200a), and stores a result of the analysis in the message communication unit division organization information (300a1) or the message modulation unit division organization information (300a2).
36. The communication analysis apparatus of any one of Claims 24 to 35, comprising
   division organization information-added display data generation means (111) including two or more display data generators, wherein
   the division organization information-added display data generation means (111) receives input of an analysis result of the division data analyzed by the signal analysis means, generates display data by converting the analysis result of the division data using the display data generators, stores a predetermined number of the display data, and generates division organization information-added display data (200c) with the added division organization information including division unit information about the predetermined number.
37. The communication analysis apparatus of Claim 36, wherein
   the division organization information-added display data generation means 111 inputs an analysis result of the division data corresponding to each display data generator, into the display data generator on the basis of the division organization information about the inputted division data.
38. The communication analysis apparatus of Claim 37, wherein
   the division organization information-added display data generation means (111) sets the basic ID of the division organization information added to the division data that is the generation source of the display data, as the association ID of the division organization information of the display data.
39. The communication analysis apparatus of any one of Claims 36 to 38, wherein
   the division organization information-added display data generation means (111) adds, to the display data, the division organization information where the division unit is a display range number, as display division organization information (300c1).
40. The communication analysis apparatus of any one of Claims 36 to 39, wherein
   the division organization information-added display data generation means (111) adds, to the display data, the division organization information where the division unit is a selection range number, as selection division organization information (300c2).
41. A communication analysis apparatus for analyzing data acquired from a transmission path of a communication network, the communication analysis apparatus comprising
   signal analysis result display means including:
   display range data storage means for storing display data obtained by converting an analysis result of division data, which is obtained by dividing the data into predetermined lengths, for a display purpose;
   display data specification means for specifying display range data that is a data width for displaying the display data;
   associated display data extraction means for extracting the display data corresponding to the specified display range data from the display range data storage means; and
   two or more analysis result display means, wherein
   the two or more analysis result display means display the predetermined display data corresponding to the analysis result display means among the extracted display data.
42. The communication analysis apparatus of Claim 41, wherein
   the display range data storage means stores display data obtained by converting an analysis result of the division data, in which the data is a communication message or a waveform signal, for a display purpose.
43. The communication analysis apparatus of Claim 41 or 42, wherein
   the analysis result display means include at least one of spectrum display means for displaying a power spectrum of the waveform signal, constellation display means for displaying an in-phase component and an out-of-phase component of the waveform signal, MER display means for displaying an MER of the waveform signal, and disturbance factor display means for displaying an inference result of a disturbance factor of the waveform signal.
44. The communication analysis apparatus of any one of Claims 41 to 43, wherein
   the display data specification means specifies one or more selection data as well as the display range data, which are data widths for selecting and displaying a predetermined number of the display data,
   the associated display data extraction means extracts, from the display range data storage means, the display data corresponding to the specified selection data among display data corresponding to the extracted display range data, and
   the analysis result display means display the display data corresponding to the extracted selection data in such a manner that the display data is distinguished from other display data.
45. The communication analysis apparatus of Claim 44, wherein
   the display range data storage means stores, as the display data, one or more division organization information-added display data (200c) according to Claim 36,
   the display data specification means specifies, as the display range data, a display range number included in display division organization information (300c1) according to Claim 39 added to the division organization information-added display data (200c), and specifies, as the selection data, a selection range number included in selection division organization information (300c2) according to Claim 40 added to the division organization information-added display data (200c),
   the associated display data extraction means extracts the display data included in other display division organization information (300c1) having the association ID identical to the association ID included in the display division organization information (300cl) corresponding to the specified display range data, and extracts the associated data included in other selection division organization information (300c2) having the association ID identical to the association ID included in the selection division organization information (300c2) corresponding to the specified selection data.
46. A communication analysis apparatus for analyzing data acquired from a transmission path of a communication network, the communication analysis apparatus comprising:
   division organization information addition means according to any one of Claims 1 to 13;
   division organization information-added data generation means according to any one of Claims 14 to 19;
   data synchronization means according to any one of Claims 20 to 23;
   signal analysis means according to any one of Claims 24 to 40; and
   signal analysis result display means according to any one of Claims 41 to 45.
47. The communication analysis apparatus of Claim 46, wherein
   the communication network is any one of in-house communication, power line communication, a wireless communication signal, and inter-control apparatus communication.
48. The communication analysis apparatus of Claim 47, wherein
   the control apparatus is an air-conditioner.
49. A communication analysis method for analyzing data acquired from a transmission path of a communication network, the communication analysis method comprising:
   a step of acquiring a plurality of division data, which are obtained by dividing the data into predetermined lengths; and
   a division organization information addition step of adding division organization information, which includes division unit information for defining the predetermined lengths and division position information being information about start positions and end positions of the division data in the data, to the division data.
50. The communication analysis method of Claim 49, wherein
   in the division organization information addition step, when predetermined lengths are time lengths, information indicating start time and end time of the division data is added as the division position information.
51. The communication analysis method of Claim 49 or 50, wherein
   in the division organization information addition step, a basis IC unique to each of the pieces of division organization information is created and the division organization information having the basic ID is added.
52. The communication analysis method of any one of Claims 49 to 51, wherein
   one or more basic IDs, which are included in other pieces of division organization information and have a predetermined association between the division data,
   are set as association IDs for a piece of the division organization information.
53. The communication analysis method of Claim 51 or 52, wherein
   in the division organization information addition step, a hierarchical relation of each piece of the division organization information is defined in accordance with sizes of the predetermined lengths, and
   when the division data corresponding to the division organization information located at a higher level of hierarchy includes the division data corresponding to the division organization information located at a lower level of hierarchy, the basic IDs indicating that the division organization information located at a higher level of hierarchy and the division organization information located at a lower level of hierarchy can be cross-referential are created.
54. The communication analysis method of Claim 53, wherein
   in the division organization information addition step, the cross-referential basic IDs are created by incorporating the basic ID of the division organization information located at a higher level of hierarchy into the basic ID of the division organization information located at a lower level of hierarchy.
55. The communication analysis method of any one of Claims 49 to 54, wherein
   the division data are communication messages.
56. The communication analysis method of Claim 55, wherein
   in the division organization information addition step, the division organization information where the division unit information is a communication unit is added as message communication unit division organization information (300a1) to the division data.
57. The communication analysis method of Claim 56, wherein
   the message communication unit division organization information (300a1) includes information about a communication protocol conformed to by the division data.
58. The communication analysis method of any one of Claims 55 to 57, wherein
   in the division organization information addition step, the division organization information where the division unit information is a modulation unit is added as message modulation unit division organization information (300a2) to the division data.
59. The communication analysis method of any one of Claims 49 to 54, wherein
   the division data are waveform signals.
60. The communication analysis method of Claim 59, wherein
   in the division organization information addition step, the division organization information where the division unit is a communication unit is added as waveform communication unit division organization information (300b1) to the division data.
61. The communication analysis method of Claim 59 or 60, wherein in the division organization information addition step, the division organization information where the division unit is a modulation unit is added as waveform modulation unit division organization information (300b2) to the division data.
62. The communication analysis method of any one of Claims 49 to 61, comprising
   a division organization information-added data generation step of generating division organization information-added data including the data as the original data, preceding the division organization information addition step.
63. The communication analysis method of Claim 62, wherein
   the division organization information-added data is generated by adding the division organization information to each of the pieces of division data obtained by dividing the original data into the predetermined lengths, in the division organization information addition step.
64. The communication analysis method of Claim 62 or 63, wherein
   the division organization information-added data includes data information, and
   the data information includes original data acquisition time information indicating the time when the original data has been acquired.
65. The communication analysis method of any one of Claims 62 to 64, wherein
   in the division organization information-added data generation step, the division organization information-added data where the original data is the original communication message and the division data are division communication messages is generated as a division organization information-added communication message (200a), and
   the division organization information-added communication message (200a) is generated by adding, as the division organization information, message communication unit division organization information (300a1) according to Claim 56 and/or message modulation unit division organization information (300a2) according to Claim 58.
66. The communication analysis method of any one of Claims 62 to 65, wherein
   in the division organization information-added data generation step, the division organization information-added data where the original data is the original waveform signal and the division data are division waveform signals, is generated as a division organization information-added waveform signal (200b), and
   the division organization information-added waveform signal (200b) is generated by adding, as the division organization information, waveform communication unit division organization information (300b1) according to Claim 60 and/or waveform modulation unit division organization information (300b2) according to Claim 61.
67. The communication analysis method of Claim 66, wherein
   the data information includes information indicating a sampling rate of the original waveform signal.
68. A communication analysis method comprising
   a data synchronization step including:
   a division organization information-added communication message storage step of storing one or more division organization information-added communication messages (200a) according to Claim 65, with the added message communication unit division organization information (300a1) according to Claim 56;
   a division organization information-added waveform signal storage step of storing one or more division organization information-added waveform signals (200b) according to Claim 66, with the added waveform communication unit division organization information (300b1) according to Claim 60;
   a step of acquiring one or more synchronization determination conditions; and
   a synchronization determination step of setting the basic ID of the waveform communication unit division organization information (300b1) as the association ID of the message communication unit division organization information (300a1) at the time when the message communication unit division organization information (300a1) and the waveform communication unit division organization information (300b1) meet the synchronization determination conditions, and setting the basic ID of the message communication unit division organization information (300a1) as the association ID of the waveform communication unit division organization information (300b1).
69. The communication analysis method of Claim 68, wherein
   in the division organization information-added communication message storage step, the one or more division organization information-added communication messages (200a) with the added message modulation unit division organization information (300a2) according to Claim 58 are stored,
   in the division organization information-added waveform signal storage step, the one or more division organization information-added waveform signals (200b) with the added waveform modulation unit division organization information (300b2) according to Claim 61 are stored, and
   in the synchronization determination step, when the message modulation unit division organization information (300a2) and the waveform modulation unit division organization information (300b2) meet the synchronization determination conditions, the basic ID of the waveform modulation unit division organization information (300b2) is set as the association ID of the message modulation unit division organization information (300a2) and the basic ID of the message modulation unit division organization information (300a2) is set as the association ID of the waveform modulation unit division organization information (300b2).
70. The communication analysis method of Claim 69, wherein
   the message communication unit division organization information (300a1), the waveform communication unit division organization information (300b1), the message modulation unit division organization information (300a2), and the waveform modulation unit division organization information (300b2) each include information indicating start time and end time of the division data, and
   in the synchronization determination step, whether both a difference between the start time and a difference between the end time are equal to or smaller than a predetermined time error threshold is used as the synchronization determination conditions.
71. The communication analysis method of any one of Claims 68 to 70, wherein
   in the division organization information-added communication message storage step, a communication message notified by communication means is acquired one after another and, each time notification of the communication message is notified, the division organization information-added communication message (200a) is generated and the communication message is stored, and
   in the division organization information-added waveform signal storage step, a waveform signal notified by waveform measuring means is acquired one after another and, each time notification of the waveform signal is notified, the division organization information-added communication message (200a) is generated and the waveform signal is stored.
72. A communication analysis method for analyzing data acquired from a transmission path of a communication network, the communication analysis method comprising
   a signal analysis step including:
   a division data acquisition step of acquiring division data obtained by dividing the data into predetermined lengths, with the added division organization information according to the data;
   an analysis condition acquisition step of acquiring one or more analysis conditions;
   a division data selection step of selecting the division data meeting the analysis conditions on the basis of the division organization information; and
   an analysis step of analyzing the selected division data using an analyzer.
73. The communication analysis method of Claim 72, wherein
   in the analysis step, information indicating an analysis result of the division data is stored in the division organization information.
74. The communication analysis method of Claim 72 or 73, wherein
   in the analysis condition acquisition step, a condition whether a communication protocol conformed to by the division data matches a communication protocol conformed to by the analyzer is acquired as the analysis condition.
75. The communication analysis method of any one of Claims 72 to 74, wherein
   in the analysis condition acquisition step, information for defining the predetermined lengths of the division organization information, is acquired as the analysis condition.
76. The communication analysis method of any one of Claims 72 to 75, wherein
   in the analysis step, a waveform signal of the selected division data is analyzed using a waveform analyzer for analyzing the division data where the data is a waveform signal.
77. The communication analysis method of Claim 76, wherein
   in the analysis step, the waveform signal is analyzed using at least one of a Fourier transformer for deriving a frequency component of the waveform signal, a spectrum calculator for calculating a power spectrum of the waveform signal, an I-Q calculator for calculating an in-phase component and an out-of-phase component of the waveform signal, an MER calculator for calculating an MER of the waveform signal, and a disturbance diagnostic apparatus for inferring a disturbance factor of the waveform signal.
78. The communication analysis method of Claim 66 or 67, wherein
   in the division data acquisition step, a division organization information-added waveform signal (200b) according to Claim 66 or 68 is acquired,
   in the division data selection step, the division organization information-added waveform signal (200b) meeting the analysis conditions is selected on the basis of waveform communication unit division organization information (300b1) according to Claim 60 added to the division organization information-added waveform signal (200b), or waveform modulation unit division organization information (300b2) according to Claim 61 added to the division organization information-added waveform signal (200b), and
   in the analysis step, the division waveform signal of the selected division organization information-added waveform signal (200b) is analyzed and a result of the analysis is stored in the waveform communication unit division organization information (300b1) or the waveform modulation unit division organization information (300b2).
79. The communication analysis method of Claim 78, wherein
   in the analysis step, information about the communication protocol of the message communication unit division organization information (300a1) having, as the basic ID, the association ID of the waveform communication unit division organization information (300b1) set in a data synchronization step according to any one of Claims 68 to 71 is used as a communication protocol conformed to by the division waveform signal of the division organization information-added waveform signal (200b) with the waveform communication unit division organization information (300b1).
80. The communication analysis method of Claim 79, comprising
   a division organization information addition step according to any one of Claims 60 and 61, preceding the signal analysis step, wherein
   in the division organization information addition step, the communication unit division organization information (300b1) including information about a communication protocol conformed to by the division waveform signal or the waveform modulation unit division organization information (300b2) including information about a communication protocol conformed to by the division waveform signal is added to the division organization information-added waveform signal (200b).
81. The communication analysis method of any one of Claims 72 to 75, wherein
   in the analysis step, a communication message of the selected division data is analyzed using an communication analyzer for analyzing the division data where the data is a communication message.
82. The communication analysis method of Claim 81, wherein
   in the analysis step, the communication message is analyzed using at least one of an address analyzer for deriving a destination address and a source address of the communication message and a CRC error determination apparatus for deriving a CRC error of the communication message.
83. The communication analysis method of Claim 81 or 82, wherein
   in the division data acquisition step, a division organization information-added communication message (200a) according to Claim 65 or 68 is acquired,
   in the division data selection step, the division organization information-added communication message (200a) meeting the analysis conditions is selected on the basis message communication unit division organization information (300a1) according to Claim 56 added to the division organization information-added communication messages (200a) or message modulation unit division organization information (300a2) according to Claim 58 added to the division organization information-added communication messages (200a), and
   in the analysis step, the division communication message of the selected division organization information-added communication message (200a) is analyzed and a result of the analysis is stored in the message communication unit division organization information (300a1) or the message modulation unit division organization information (300a2).
84. The communication analysis method of any one of Claims 72 to 83, comprising
   division organization information-added display data generation step, succeeding the signal analysis step, the division organization information-added display data generation step including:
   a step of acquiring an analysis result of the division data analyzed in the signal analysis step;
   a display data generation step of generating display data by converting the acquired analysis result of the division data using one or more display data generators; and
   a division organization information generation step of generating division organization information-added display data (200c) with the added division organization information including a predetermined number of the display data and division unit information about the predetermined number.
85. The communication analysis method of Claim 84, wherein
   in the display data generation step, the display data is generated by converting an analysis result of the division data corresponding to each display data generator using the display data generator, on the basis of the division organization information of the acquired division data.
86. The communication analysis method of Claim 85, wherein
   in the division organization information generation step, the basic ID of the division organization information added to the division data that is the generation source of the display data is set as the association ID of the division organization information of the display data.
87. The communication analysis method of any one of Claims 84 to 86, wherein
   in the division organization information generation step, the division organization information where the division unit is a display range number is added as display division organization information (300c1) to the display data.
88. The communication analysis method of any one of Claims 84 to 87, wherein
   in the division organization information generation step, the division organization information where the division unit is a selection range number is added as selection division organization information (300c2) to the display data.
89. A communication analysis method for analyzing data acquired from a transmission path of a communication network, the communication analysis method comprising
   a signal analysis result display step including:
   a display range data storage step of storing display data obtained by converting an analysis result of division data obtained by dividing the data into predetermined lengths, for a display purpose;
   a display data specification step of specifying display range data that are data widths for displaying the display data;
   an associated display data extraction step of extracting the display data corresponding to the specified display range data from the stored display data; and
   an analysis result display step of displaying the predetermined display data among the extracted display data.
90. The communication analysis method of Claim 89, wherein
   in the display range data storage step, display data obtained by converting an analysis result of the division data where the data is a communication message or a waveform signal, for a display purpose, are stored.
91. The communication analysis method of Claim 89 or 90, wherein
   in the analysis result display step, by using at least one of spectrum display means for displaying a power spectrum of the waveform signal, constellation display means for displaying an in-phase component and an out-of-phase component of the waveform signal, MER display means for displaying an MER of the waveform signal, and disturbance factor display means for displaying an inference result of a disturbance factor of the waveform signal, the predetermined display data corresponding to each of the display means among the extracted display data are displayed.
92. The communication analysis method of any one of Claims 89 to 91, wherein
   in the display data specification step, one or more selection data, which are data widths for selecting and displaying the display data by a predetermined number, are specified as well as the display range data,
   in the associated display data extraction step, the display data corresponding to the specified selection data among display data corresponding to the extracted display range data are extracted from the stored display data, and
   in the analysis result display step, the display data corresponding to the extracted selection data is displayed in such a manner that the display data is distinguished from other display data.
93. The communication analysis method of Claim 92, wherein
   in the display range data storage step, one or more division organization information-added display data (200c) according to Claim 84 are stored as the display data,
   in the display data specification step, a display range number included in display division organization information (300c1) according to Claim 87 added to the division organization information-added display data (200c) is specified as the display range data and a selection range number included in selection division organization information (300c2) according to Claim 88 added to the division organization information-added display data (200c) is specified as the selection data, and
   in the associated display data extraction step, the display data included in other display division organization information (300c1) having the association ID identical to the association ID of the display division organization information (300c1) corresponding to the specified display range data is extracted and the associated data included in other selection division organization information (300c2) having the association ID identical to the association ID of the selection division organization information (300c2) corresponding to the specified selection data is extracted.
94. A communication analysis method for analyzing data acquired from a transmission path of a communication network, the communication analysis method comprising:
   a division organization information addition step according to any one of Claims 49 to 61;
   a division organization information-added data generation step according to any one of Claims 62 to 67;
   a data synchronization step according to any one of Claims 68 to 71;
   a signal analysis step according to any one of Claims 72 to 88; and
   a signal analysis result display step of any one of Claims 89 to 93.
95. The communication analysis method of Claim 94, wherein
   the communication network is any one of in-house communication, power line communication, a wireless communication signal, and inter-control apparatus communication.
96. The communication analysis method of Claim 95, wherein
   the control apparatus is an air-conditioner.
97. A communication analysis apparatus connected to a transmission path through which a plurality of apparatuses transmits or receives a message conforming to a predetermined communication protocol with one another, the communication analysis apparatus comprising:
   ideal waveform information storage means for retaining an ideal waveform signal conforming to the communication protocol;
   analysis waveform information generation means; and
   communication state determination means, wherein
   the analysis waveform information generation means extracts, as an analysis waveform signal, a portion corresponding to the ideal waveform signal and a time of a waveform signal received from the transmission path, and
   the communication state determination means estimates a communication state of the transmission path on the basis of an analysis waveform signal extracted by the analysis waveform information generation means and an ideal waveform signal stored in the ideal waveform information storage means.
98. A communication analysis apparatus connected to a transmission path through which a message is transmitted or received among a plurality of apparatuses, the communication analysis apparatus comprising:
   ideal waveform information storage means for retaining an ideal waveform signal conforming to a predetermined communication protocol;
   analysis waveform information generation means; and
   communication state determination means, wherein
   the analysis waveform information generation means extracts, from a message received from the transmission path, a message having a communication protocol matching a communication protocol of the ideal waveform signal and a waveform signal corresponding to the message, and extracts a portion of the extracted waveform signal corresponding to the ideal waveform signal and a time as an analysis waveform signal, and
   the communication state determination means estimates a communication state of the transmission path on the basis of an analysis waveform signal extracted by the analysis waveform information generation means and an ideal waveform signal stored in the ideal waveform information storage means.
99. The communication analysis apparatus of Claim 97 or 98, comprising
   waveform characteristic amount calculation means for calculating a characteristic amount of the analysis waveform signal and a characteristic amount of the ideal waveform signal, wherein
   the communication state determination means estimates a communication state of the transmission path by comparing a characteristic amount of an analysis waveform signal outputted from the waveform characteristic amount calculation means with a characteristic amount of an ideal waveform signal.
100. The communication analysis apparatus of Claim 99, wherein
   a characteristic amount calculated by the waveform characteristic amount calculation means includes a phase component at a time when the analysis waveform signal and the ideal waveform signal are partitioned into predetermined lengths.
101. The communication analysis apparatus of Claim 100, wherein
   the communication state determination means compares the analysis waveform signal with the ideal waveform signal using a difference between distributions of the phase component in the predetermined lengths.
102. The communication analysis apparatus of any one of Claims 99 to 101, wherein
   a characteristic amount calculated by the waveform characteristic amount calculation means includes an amplitude component at a time when the analysis waveform signal and the ideal waveform signal are partitioned into predetermined lengths.
103. The communication analysis apparatus of Claim 102, wherein
   the communication state determination means compares the analysis waveform signal with the ideal waveform signal using a difference between distributions of the amplitude component in the predetermined lengths.
104. The communication analysis apparatus of any one of Claims 98 to 103, comprising
   synchronization determination means, wherein
   the synchronization determination means associates a waveform signal transmitted through the transmission path and a communication message transmitted through the transmission path with each other using a time.
105. The communication analysis apparatus of Claim 104, comprising analysis waveform information storage means, wherein
   the analysis waveform information storage means stores the analysis waveform signal and a communication message associated with the waveform signal in combination.
106. The communication analysis apparatus of Claim 105, wherein the communication state estimated by the communication state determination means includes a state of deterioration with time of the transmission path.
107. The communication analysis apparatus of Claim 105 or 106, wherein
   the communication state estimated by the communication state determination means includes a length of a transmission path linking a source terminal of the analysis waveform signal and a destination terminal thereof.
108. The communication analysis apparatus of any one of Claims 105 to 107, wherein
   the communication state estimated by the communication state determination means includes a failure part of a source terminal or a destination terminal of the analysis waveform signal.
109. The communication analysis apparatus of any one of Claims 105 to 108, wherein
   the communication state estimated by the communication state determination means includes the number of terminals connected to the whole transmission path.
110. The communication analysis apparatus of any one of Claims 105 to 109, wherein
   the communication state estimated by the communication state determination means includes a name of a noise source.
111. The communication analysis apparatus of any one of Claims 104 to 110, comprising:
   communication means; and
   waveform measuring means, wherein
   the communication means receives a communication message from the transmission path and the acquisition time of the communication message one after another and notifies first storage means of the communication message and the acquisition time,
   the waveform measuring means receives a waveform signal from the transmission path and the acquisition time of the waveform signal one after another and notifies second storage means of the waveform signal and the acquisition time,
   the first storage means stores the communication message and the acquisition time thereof,
   the second storage means stores the waveform signal and the acquisition time thereof, and
   the synchronization determination means operates when a difference between the acquisition time of the communication message stored in the first storage means and the acquisition time of the waveform signal stored in the second storage means is equal to or smaller than a predetermined value.
112. The communication analysis apparatus of any one of Claims 97 to 111, comprising
   analysis result display means, wherein
   the analysis result display means displays a communication state of the transmission path estimated by the communication state determination means.

## Claims

1. A communication analysis apparatus connected to a transmission path through which a message is transmitted or received among a plurality of apparatuses, the communication analysis apparatus comprising:
ideal waveform information storage means (112A) for retaining an ideal waveform signal conforming to a predetermined communication protocol;
analysis waveform information generation means (109A) ;
communication state determination means (113A), wherein
the analysis waveform information generation means (109A) is adapted to extract, from a message received from the transmission path, a message having a communication protocol matching a communication protocol of the ideal waveform signal and a waveform signal corresponding to the message, and to extract a portion of the extracted waveform signal corresponding to the ideal waveform signal and a time as an analysis waveform signal, and
the communication state determination means (113A) is adapted to estimate a communication state of the transmission path on the basis of the analysis waveform signal extracted by the analysis waveform information generation means (109A) and the ideal waveform signal stored in the ideal waveform information storage means (112A),
the communication analysis apparatus further comprising:
communication means (101A);
waveform measuring means (102A); and
synchronization determination means (108A), wherein:
the communication means (101A) is adapted to receive a communication message from the transmission path and the acquisition time of the communication message one after another and to notify first storage means (103A) of the communication message and the acquisition time,
the waveform measuring means (102A) is adapted to receive a waveform signal from the transmission path and the acquisition time of the waveform signal one after another and to notify second storage means (104A) of the waveform signal and the acquisition time,
the first storage means (103A) is adapted to store the communication message and the acquisition time thereof,
the second storage means (104A) is adapted to store the waveform signal and the acquisition time thereof, and
the synchronization determination means (108A) is adapted to associate a waveform signal transmitted through the transmission path and a communication message transmitted through the transmission path, the synchronization determination means (108A) being adapted to operate when a difference between the acquisition time of the communication message stored in the first storage means (103A) and the acquisition time of the waveform signal stored in the second storage means (104A) is equal to or smaller than a predetermined value.

2. The communication analysis apparatus of Claim 1, comprising:
waveform characteristic amount calculation means (111 A) for calculating a characteristic amount of the analysis waveform signal and a characteristic amount of the ideal waveform signal, wherein:
the communication state determination means (113A) estimates a communication state of the transmission path by comparing the characteristic amount of the analysis waveform signal outputted from the waveform characteristic amount calculation means (111A) with the characteristic amount of the ideal waveform signal stored in the ideal waveform information storage means (112A).

3. The communication analysis apparatus of Claim 2, wherein:
the characteristic amount calculated by the waveform characteristic amount calculation means (111A) includes a phase component at a time when the analysis waveform signal and the ideal waveform signal are partitioned into predetermined lengths, and
the communication state determination means (113A) compares the analysis waveform signal with the ideal waveform signal using a difference between distributions of the phase component in the predetermined lengths.

4. The communication analysis apparatus of Claim 2, wherein:
the characteristic amount calculated by the waveform characteristic amount calculation means (111A) includes an amplitude component at a time when the analysis waveform signal and the ideal waveform signal are partitioned into predetermined lengths, and
the communication state determination means (113A) compares the analysis waveform signal with the ideal waveform signal using a difference between the distributions of the amplitude component in the predetermined lengths.

5. The communication analysis apparatus of Claim 2, wherein:
comparison value of the characteristic amount is a difference between the largest amplitude values or average amplitude values.

6. The communication analysis apparatus of Claim 2, wherein:
comparison value of the characteristic amount is the difference between power of particular frequencies.

7. The communication analysis apparatus of any one of Claim 1, comprising:
analysis waveform information storage means (110A), wherein:
the analysis waveform information storage means (110A) stores the analysis waveform signal and a communication message associated with the waveform signal transmitted through the transmission path in combination.

8. The communication analysis apparatus of any one of Claim 7, wherein:
the communication state estimated by the communication state determination means (113A) includes a length of a transmission path linking a source terminal of the analysis waveform signal and a destination terminal thereof.

9. The communication analysis apparatus of any one of Claim 7 or 8, wherein:
the communication state estimated by the communication state determination means (113A) includes a failure part of a source terminal or a destination terminal of the analysis waveform signal.

10. The communication analysis apparatus of any one of Claims 7 to 9, wherein:
the communication state estimated by the communication state determination means (113A) includes number of terminals connected to the whole transmission path.

11. The communication analysis apparatus of any one of Claims 7 to 10, wherein:
the communication state estimated by the communication state determination means (113A) includes a name of a noise source.

12. The communication analysis apparatus of any one of Claims 1 to 11, comprising:
analysis result display means (114A), wherein:
the analysis result display means (114A) displays a communication state of the transmission path estimated by the communication state determination means (113A).

## Patentansprüche

1. Kommunikationsanalysevorrichtung, verbunden mit einer Übertragungsstrecke, über welche zwischen einer Mehrzahl von Vorrichtungen eine Nachricht gesendet oder empfangen wird, wobei die Kommunikationsanalysevorrichtung umfasst:
ein Idealwellenforminformationsspeichermittel (112A) zum Vorhalten eines idealen, einem vorgegebenen Kommunikationsprotokoll entsprechenden Wellenformsignals;
ein Analysewellenforminformationserzeugungsmittel (109A);
ein Kommunikationszustandsbestimmungsmittel (113A), wobei
das Analysewellenforminformationserzeugungsmittel (109A) dazu eingerichtet ist, aus einer über die Übertragungsstrecke empfangene Nachricht eine Nachricht eines Kommunikationsprotokolls, welches mit einem Kommunikationsprotokoll des idealen Wellenformsignals übereinstimmt, und ein der Nachricht entsprechendes Wellenformsignal zu extrahieren, und einen Abschnitt des dem idealen Wellenformsignal entsprechenden, extrahierten Wellenformsignals und eine Zeit als ein Analysewellenformsignal zu extrahieren, und
das Kommunikationszustandsbestimmungsmittel (113A) dazu eingerichtet ist, einen Kommunikationszustand der Übertragungsstrecke auf der Basis des durch das Analysewellenforminformationserzeugungsmittel (109A) entnommenen Analysewellenformsignals und des in dem Idealwellenforminformationsspeichermittels (112A) gespeicherten idealen Wellenformsignal zu schätzen,
wobei die Kommunikationsanalysevorrichtung ferner aufweist:
ein Kommunikationsmittel (101A);
ein Wellenformerfassungsmittel (102A); und
ein Synchronisationsbestimmungsmittel (108A), wobei:
das Kommunikationsmittel (101A) dazu eingerichtet ist, eine Kommunikationsnachricht von der Übertragungsstrecke und die Erfassungszeit der Kommunikationsnachricht nacheinander zu empfangen und ein erstes Speichermittel (103A) über die Kommunikationsnachricht und die Erfassungszeit zu benachrichtigen,
das Wellenformerfassungsmittel (102A) dazu eingerichtet ist, ein Wellenformsignal von der Übertragungsstrecke und die Erfassungszeit des Wellenformsignals nacheinander zu empfangen und ein zweites Speichermittel (104A) über das Wellenformsignal und die Erfassungszeit zu benachrichtigen,
das erste Speichermittel (103A) dazu eingerichtet ist, die Kommunikationsnachricht und die Erfassungszeit davon zu speichern,
das zweite Speichermittel (104A) dazu eingerichtet ist, das Wellenformsignal und die Erfassungszeit davon zu speichern, und
das Synchronisationsbestimmungsmittel (108A) dazu eingerichtet ist, ein über die Übertragungsstrecke gesendetes Wellenformsignal und eine über die Übertragungsstrecke gesendete Kommunikationsnachricht zu assoziieren, wobei das Synchronisationsbestimmungsmittel (108A) dazu eingerichtet ist, in Betrieb zu sein, wenn eine Differenz zwischen der Erfassungszeit der in dem ersten Speichermittel (103A) gespeicherten Kommunikationsnachricht und der Erfassungszeit des in dem zweiten Speichermittel (104A) gespeicherten Wellenformsignals kleiner oder gleich einem vorgegebenen Wert ist.

2. Kommunikationsanalysevorrichtung gemäß Anspruch 1, aufweisend:
ein Wellenformcharakteristikgrößenberechnungsmittel (111A) zum Berechnen einer Charakteristikgröße des Analysewellenformsignals und einer Charakteristikgröße des idealen Wellenformsignals, wobei:
das Kommunikationszustandsbestimmungsmittel (113A) einen Kommunikationszustand der Übertragungsstrecke durch Vergleichen der Charakteristikgröße des von dem Wellenformcharakteristikgrößenberechnungsmittel (111A) ausgegebenen Analysewellenformsignals mit der Charakteristikgröße des in dem Idealwellenforminformationsspeichermittel (112A) gespeicherten idealen Wellenformsignals schätzt.

3. Kommunikationsanalysevorrichtung gemäß Anspruch 2, wobei:
die durch das Wellenformcharakteristikgrößenberechnungsmittel (111A) berechnete Charakteristikgröße zu einem Zeitpunkt, zu dem das Analysewellenformsignal und das ideale Wellenformsignal in vorgegebene Längen aufgeteilt sind, eine Phasenkomponente umfasst, und
das Kommunikationszustandsbestimmungsmittel (113A) das Analysewellenformsignal mit dem idealen Wellenformsignal mittels einer Differenz zwischen Verteilungen der Phasenkomponente in den vorgegebenen Längen vergleicht.

4. Kommunikationsanalysevorrichtung gemäß Anspruch 2, wobei:
die durch das Wellenformcharakteristikgrößenberechnungsmittel (111A) berechnete Charakteristikgröße zu einem Zeitpunkt, zu dem das Analysewellenformsignal und das ideale Wellenformsignal in vorgegebene Längen aufgeteilt sind, eine Amplitudenkomponente umfasst, und
das Kommunikationszustandsbestimmungsmittel (113A) das Analysewellenformsignal mit dem idealen Wellenformsignal mittels einer Differenz zwischen den Verteilungen der Amplitudenkomponente in den vorgegebenen Längen vergleicht.

5. Kommunikationsanalysevorrichtung gemäß Anspruch 2, wobei:
ein Vergleichswert der Charakteristikgröße eine Differenz zwischen den größten Amplitudenwerten oder durchschnittlichen Amplitudenwerten ist.

6. Kommunikationsanalysevorrichtung gemäß Anspruch 2, wobei:
ein Vergleichswert der Charakteristikgröße eine Differenz zwischen Leistungen bestimmter Frequenzen ist.

7. Kommunikationsanalysevorrichtung gemäß Anspruch 1, aufweisend:
ein Analysewellenforminformationsspeichermittel (110A), wobei:
das Analysewellenforminformationsspeichermittel (110A) das Analysewellenformsignal und eine dem Wellenformsignal zugehörige, über die Übertragungsstrecke übertragene Kommunikationsnachricht in Kombination speichert.

8. Kommunikationsanalysevorrichtung gemäß Anspruch 7, wobei:
der durch das Kommunikationszustandsbestimmungsmittel (113A) geschätzte Kommunikationszustand eine Länge einer ein Quellenterminal des Analysewellenformsignals und ein Zielterminal desselben verbindende Übertragungsstrecke umfasst.

9. Kommunikationsanalysevorrichtung gemäß einem der Ansprüche 7 oder 8, wobei:
der durch das Kommunikationszustandsbestimmungsmittel (113A) geschätzte Kommunikationszustand einen Fehlerteil eines Quellenterminals oder eines Zielterminals des Analysewelleformsignals umfasst.

10. Kommunikationsanalysevorrichtung gemäß einem der Ansprüche 7 bis 9, wobei:
der durch das Kommunikationszustandsbestimmungsmittel (113A) geschätzte Kommunikationszustand eine Zahl von mit der gesamten Übertragungsstrecke verbundenen Terminals umfasst.

11. Kommunikationsanalysevorrichtung gemäß einem der Ansprüche 7 bis 10, wobei:
der durch das Kommunikationszustandsbestimmungsmittel (113A) geschätzte Kommunikationszustand einen Namen einer Rauschquelle umfasst.

12. Kommunikationsanalysevorrichtung gemäß einem der Ansprüche 1 bis 11, aufweisend:
ein Analyseergebnisanzeigemittel (114A), wobei:
das Analyseergebnisanzeigemittel (114A) einen durch das Kommunikationszustandsbestimmungsmittel (113A) geschätzten Kommunikationszustand der Übertragungsstrecke anzeigt.

## Revendications

1. Appareil d'analyse de communication connecté à un chemin de transmission grâce auquel un message est transmis ou reçu parmi une pluralité d'appareils, l'appareil d'analyse de communication comprenant :
des moyens de stockage d'informations de forme d'onde idéale (112A) destinés à conserver un signal de forme d'onde idéale qui se conforme à un protocole de communication prédéterminé ;
des moyens de génération d'informations de forme d'onde d'analyse (109A) ;
des moyens de détermination d'état de communication (113A), dans lequel :
les moyens de génération d'informations de forme d'onde d'analyse (109A) sont adaptés de façon à extraire, à partir d'un message reçu en provenance du chemin de communication, un message qui présente un protocole de communication qui correspond à un protocole de communication du signal de forme d'onde idéale et d'un signal de forme d'onde qui correspond au message, et à extraire une partie du signal de forme d'onde extrait qui correspond au signal de forme d'onde idéale et un instant en tant que signal de forme d'onde d'analyse ; et
les moyens de détermination d'état de communication (113A) sont adaptés de façon à estimer un état de communication du chemin de transmission sur la base du signal de forme d'onde d'analyse extrait par les moyens de génération d'informations de forme d'onde d'analyse (109A), et du signal de forme d'onde idéale stocké dans les moyens de stockage d'informations de forme d'onde idéale (112A) ;
l'appareil d'analyse de communication comprenant en outre :
des moyens de communication (101A) ;
des moyens de mesure de forme d'onde (102A) ; et
des moyens de détermination de synchronisation (108A), dans lequel :
les moyens de communication (101A) sont adaptés de façon à recevoir un message de communication en provenance du chemin de transmission et l'instant d'acquisition du message de communication l'un après l'autre, et à informer les premiers moyens de stockage (103A) du message de communication et de l'instant d'acquisition ;
les moyens de mesure de forme d'onde (102A) sont adaptés de façon à recevoir un signal de forme d'onde en provenance du chemin de transmission et l'instant d'acquisition du signal de forme d'onde l'un après l'autre, et à informer des seconds moyens de stockage (104A) du signal de forme d'onde et de l'instant d'acquisition ;
les premiers moyens de mémoire (103A) sont adaptés de façon à stocker le message de communication et son instant d'acquisition ;
les seconds moyens de mémoire (104A) sont adaptés de façon à stocker le signal de forme d'onde et son instant d'acquisition ; et
les moyens de détermination de synchronisation (108A) sont adaptés de façon à associer un signal de forme d'onde transmis grâce au chemin de communication, et un message de communication transmis grâce au chemin de communication, les moyens de détermination de synchronisation (108A) étant adaptés de façon à agir quand une différence entre l'instant d'acquisition du message de communication stocké dans les premiers moyens de stockage (103A), et l'instant d'acquisition du signal de forme d'onde stocké dans les seconds moyens de stockage (104A), est égale ou inférieure à une valeur prédéterminée.

2. Appareil d'analyse de communication selon la revendication 1, comprenant :
des moyens de calcul de quantité de caractéristique de forme d'onde (111A) destinés à calculer une quantité de caractéristiques du signal de forme d'onde d'analyse, et une quantité de caractéristiques du signal de forme d'onde idéale, dans lequel :
les moyen de détermination d'état de communication (113A) estiment un état de communication du chemin de transmission en comparant la quantité de caractéristique du signal de forme d'onde d'analyse délivrée en sortie par les moyens de calcul de quantité de caractéristiques de forme d'onde (111A), et la quantité de caractéristique du signal de forme d'onde idéale stocké dans les moyens de stockage d'informations de forme d'onde idéale (112A).

3. Appareil d'analyse de communication selon la revendication 2, dans lequel :
la quantité de caractéristiques calculée par les moyens de calcul de quantité de caractéristique de forme d'onde (111A) inclut une composante de phase à un instant où le signal de forme d'onde d'analyse et le signal de forme d'onde idéale sont partitionnés en longueurs prédéterminées ; et
les moyens de détermination d'état de communication (113A) comparent le signal de forme d'onde d'analyse et le signal de forme d'onde idéale en utilisant une différence entre les distributions de la composante de phase dans les longueurs prédéterminées.

4. Appareil d'analyse de communication selon la revendication 2, dans lequel :
la quantité de caractéristiques calculée par les moyens de calcul de quantité de caractéristique de forme d'onde (111A) inclut une composante d'amplitude à un instant où le signal de forme d'onde d'analyse et le signal de forme d'onde idéale sont partitionnés en longueurs prédéterminées ; et
les moyens de détermination d'état de communication (113A) comparent le signal de forme d'onde d'analyse et le signal de forme d'onde idéale en utilisant une différence entre les distributions de la composante d'amplitude dans les longueurs prédéterminées.

5. Appareil d'analyse de communication selon la revendication 2, dans lequel :
la valeur de comparaison de la quantité de caractéristique est une différence entre les plus grandes valeurs d'amplitudes ou entre des valeurs d'amplitudes moyennes.

6. Appareil d'analyse de communication selon la revendication 2, dans lequel :
la valeur de comparaison de la quantité de caractéristique est la différence entre des puissances de fréquences particulières.

7. Appareil d'analyse de communication selon la revendication 1, comprenant :
des moyens de stockage d'informations de forme d'onde d'analyse (110A) ; dans lequel
les moyens de stockage d'informations de forme d'onde d'analyse (110A) stockent le signal de forme d'onde d'analyse et un message de communication associé au signal de forme d'onde transmis grâce au chemin de transmission, en association.

8. Appareil d'analyse de communication selon la revendication 7, dans lequel :
l'état de communication estimé par les moyens de détermination d'état de communication (113A) inclut une longueur d'un chemin de transmission qui relie un terminal de source du signal de forme d'onde d'analyse et un terminal de destination de celui-ci.

9. Appareil d'analyse de communication selon la revendication 7 ou la revendication 8, dans lequel :
l'état de communication estimé par les moyens de détermination d'état de communication (113A) inclut une partie défaillance d'un terminal de source ou d'un terminal de destination du signal de forme d'onde d'analyse.

10. Appareil d'analyse de communication selon l'une quelconque des revendications 7 à 9, dans lequel :
l'état de communication estimé par les moyens de détermination d'état de communication (113A) inclut le nombre de terminaux connectés à la totalité du chemin de transmission.

11. Appareil d'analyse de communication selon l'une quelconque des revendications 7 à 10, dans lequel :
l'état de communication estimé par les moyens de détermination d'état de communication (113A) inclut le nom d'une source de bruit.

12. Appareil d'analyse de communication selon l'une quelconque des revendications 1 à 11, comprenant :
des moyens d'affichage de résultat d'analyse (114A), dans lequel :
les moyens d'affichage de résultat d'analyse (114A) affichent un état de communication du chemin de transmission estimé par les moyens de détermination d'état de communication (113A).
